# EUROPEAN PATENT APPLICATION

(11) **EP 4 760 285 A1**
(43) Date of publication of application: **17.06.2026**
(21) Application number: 24882171.2
(22) Date of filing: 08.10.2024
(51) Int. Cl.: G01R 31/302, G01R 31/28, H01L 21/66

(54) **ELECTRICAL SIGNAL MEASUREMENT DEVICE AND ELECTRICAL SIGNAL MEASUREMENT METHOD**

(30) Priority: 26.10.2023 JP 2023184113
(71) Applicant: Hamamatsu Photonics K.K., Hamamatsu-shi, Shizuoka 435-8558 (JP)
(72) Inventor: NAKAMURA, Tomonori, Hamamatsu-shi, Shizuoka 435-8558 (JP); YONEDA, Mitsuyoshi, Hamamatsu-shi, Shizuoka 435-8558 (JP); NIIKURA, Fuminori, Hamamatsu-shi, Shizuoka 435-8558 (JP); UCHIYAMA, Koro, Hamamatsu-shi, Shizuoka 435-8558 (JP); EURA, Shigeru, Hamamatsu-shi, Shizuoka 435-8558 (JP)
(74) Representative: Grünecker Patent- und Rechtsanwälte PartG mbB
(86) International application number: PCT/JP2024/036012
(87) International publication number: WO 2025/089055

(57) **Abstract**

An electrical signal measurement apparatus 2A includes a signal conversion unit 30 for intensity modulating measurement light based on an electrical signal of a measurement target of a temporal waveform and outputting as an optical signal corresponding to the electrical signal, a waveform measurement unit 40 for measuring a temporal waveform of the optical signal, and a waveform analysis unit 52 for obtaining the temporal waveform of the electrical signal based on a measurement result of the optical signal. The waveform measurement unit 40 includes a streak tube 42 including a photocathode for inputting the optical signal, a sweep electrode, and a phosphor screen, an imaging element 44 for capturing a fluorescence image generated on the phosphor screen and outputting a waveform image, and an input optical system 41 for inputting the optical signal to the photocathode, the waveform analysis unit 52 obtains the temporal waveform of the electrical signal based on the waveform image, and the input optical system 41 inputs the optical signal to the photocathode as a line-shaped optical image extending in a direction intersecting with a sweep direction. Thus, an electrical signal measurement apparatus and a measurement method capable of measuring a temporal waveform of an electrical signal at high speed are realized.

## Description

### Technical Field

The present disclosure relates to an electrical signal measurement apparatus and an electrical signal measurement method for performing measurement of a temporal waveform of an electrical signal.

### Background Art

As an apparatus for measuring a temporal waveform of an electrical signal, an oscilloscope is used. Currently, a measurement bandwidth of the oscilloscope is increasing, and the oscilloscope having the bandwidth exceeding 100 GHz at the fastest is also commercially available. Further, when the case in which a high speed integration function (a phosphor mode) capable of increasing the number of integrations per unit time is used in order to perform the measurement for the temporal waveform of a weak electrical signal is considered, the input bandwidth is about 20 GHz, and the integration rate is about 20 kHz at the fastest.

### Citation List

### Patent Literature

Patent Document 1: International Publication No. 2022/064798
Patent Document 2: International Publication No. 2007/136681
Patent Document 3: European Patent Application Publication No. 0197196
Patent Document 4: European Patent Application Publication No. 0344986

### Summary of Invention

### Technical Problem

In inspection of a semiconductor device, the oscilloscope described above is used for the measurement of the temporal waveform of the electrical signal. As an inspection method for an operation state of the semiconductor device and the like, methods including an electro optical probing (EOP), an electro optical frequency mapping (EOFM), a laser voltage probing (LVP), a laser voltage imaging (LVI), and the like are known (for example, see Patent Documents 1 and 2).

In the EOP, the semiconductor device, in which a state changes over time by application of a voltage pattern of a predetermined period, is irradiated from a rear surface with probe light of a predetermined wavelength, and inspection for the operation state of the semiconductor device and the like is performed by measuring a temporal change of an intensity of reflected light. Further, in the EOFM, frequency analysis is performed with respect to the reflected light from the semiconductor device by using a spectrum analyzer, and imaging is performed for a portion operating at a predetermined frequency.

In the semiconductor inspection methods such as the EOP and the EOFM described above, the oscilloscope is used for the measurement of the temporal waveform of the electrical signal output from a photodetector with which the reflected light is detected. On the other hand, performance of LSIs continues to increase, and in the inspection of the above semiconductor devices, it may be necessary to measure jitter on the order of, for example, 10 ps. However, in the conventional oscilloscope, it is difficult to perform the measurement of the temporal waveform of the electrical signal corresponding to the temporal change of the intensity of the reflected light at high speed as described above with sufficient accuracy.

Further, in the inspection methods described above, the temporal change of the intensity in the reflected light from the semiconductor device due to the application of the voltage pattern may be very weak. In the above case, in order to measure the weak intensity change of the reflected light with a sufficient S/N ratio, a configuration may be considered in which a large number of integrations or averaging of the temporal waveform of the electrical signal output from the photodetector are performed. However, in the conventional oscilloscope, it is also difficult to perform integration of the electrical signal at high speed. The above problem of the measurement of the temporal waveform of the electrical signal at high speed similarly occurs in measurement of electrical signals other than in the semiconductor inspection.

An object of an embodiment is to provide an electrical signal measurement apparatus and an electrical signal measurement method capable of measuring a temporal waveform of an electrical signal at high speed.

### Solution to Problem

For the measurement of the temporal waveform of the electrical signal at high speed, a configuration of a streak oscilloscope may be considered in which the electrical signal is converted into an optical signal, and the optical signal is measured by using a streak camera (for example, see Patent Documents 3 and 4). However, the present inventors have conducted a detailed study on the above configuration by using the streak camera, and as a result, the present inventors have found that there are problems such as an upper limit of an input light amount density for a photocathode of the streak tube, degradation of the photocathode in the case in which the integration measurement of the temporal waveform of the optical signal is performed, and the like, and the present invention has been achieved.

An embodiment is an electrical signal measurement apparatus. The electrical signal measurement apparatus includes (1) a signal conversion unit including a measurement light source for supplying measurement light of a predetermined wavelength, and a light modulator for intensity modulating the measurement light based on an electrical signal input as a measurement target of a temporal waveform, and for outputting the measurement light after modulation by the light modulator as an optical signal having a temporal waveform corresponding to the temporal waveform of the electrical signal; (2) a waveform measurement unit for performing measurement for the temporal waveform of the optical signal output from the signal conversion unit; and (3) a waveform analysis unit for obtaining the temporal waveform of the electrical signal based on a measurement result of the temporal waveform of the optical signal by the waveform measurement unit, and (4) the waveform measurement unit includes a streak tube including a photocathode for generating electrons in response to input of the optical signal, a sweep electrode for sweeping the electrons from the photocathode in a predetermined sweep direction with a sweep period set according to the temporal waveform of the electrical signal, and a phosphor screen for inputting the electrons swept by the sweep electrode and generating a fluorescence image indicating the temporal waveform of the optical signal; an imaging element for capturing the fluorescence image generated on the phosphor screen of the streak tube, and outputting a waveform image; and an input optical system for inputting the optical signal to the photocathode, and (5) the waveform analysis unit obtains the temporal waveform of the electrical signal based on the waveform image output from the imaging element, and (6) the input optical system of the waveform measurement unit inputs the optical signal to the photocathode as a line-shaped optical image extending in a direction intersecting with the sweep direction.

An embodiment is an electrical signal measurement method. The electrical signal measurement method includes (1) a signal conversion step of using a light modulator for intensity modulating measurement light of a predetermined wavelength based on an electrical signal input as a measurement target of a temporal waveform, and outputting the measurement light after modulation by the light modulator as an optical signal having a temporal waveform corresponding to the temporal waveform of the electrical signal; (2) a waveform measurement step of performing measurement for the temporal waveform of the optical signal output in the signal conversion step; and (3) a waveform analysis step of obtaining the temporal waveform of the electrical signal based on a measurement result of the temporal waveform of the optical signal in the waveform measurement step, and (4) the waveform measurement step uses a streak tube including a photocathode for generating electrons in response to input of the optical signal, a sweep electrode for sweeping the electrons from the photocathode in a predetermined sweep direction with a sweep period set according to the temporal waveform of the electrical signal, and a phosphor screen for inputting the electrons swept by the sweep electrode and generating a fluorescence image indicating the temporal waveform of the optical signal, and captures the fluorescence image generated on the phosphor screen of the streak tube, and outputs a waveform image, and (5) the waveform analysis step obtains the temporal waveform of the electrical signal based on the waveform image output in the waveform measurement step, and (6) in the waveform measurement step, the optical signal is input to the photocathode as a line-shaped optical image extending in a direction intersecting with the sweep direction.

In the electrical signal measurement apparatus and the electrical signal measurement method described above, the electrical signal which is input as the measurement target of the temporal waveform is converted into the optical signal of the predetermined wavelength by the light modulator. Further, the temporal waveform of the optical signal is measured by the waveform measurement unit including the streak tube, and the temporal waveform of the electrical signal is obtained based on the obtained waveform image.

According to the above configuration, by performing the waveform measurement by using the streak camera including the streak tube after converting the electrical signal into the optical signal, it is possible to measure the temporal waveform of the electrical signal at high speed. Further, in the above configuration, by appropriately setting the wavelength of the measurement light used for the generation of the optical signal, the waveform measurement of the optical signal by using the streak tube can be suitably performed, and the temporal waveform of the electrical signal can be measured with high accuracy.

In addition, in the above configuration, the input optical system provided at the preceding stage of the streak tube in the waveform measurement unit has the configuration in which the optical signal is input to the photocathode as the line-shaped optical image extending in the direction intersecting with the sweep direction in the streak tube. By using the above configuration, as compared with, for example, the case in which the optical signal is input to the photocathode as a point-shaped optical image, the input light amount density is reduced to suppress degradation of the photocathode, and the measurement of the electrical signal by using the streak tube can be suitably preformed.

### Advantageous Effects of Invention

According to the electrical signal measurement apparatus and the electrical signal measurement method of the embodiments, it is possible to measure a temporal waveform of an electrical signal at high speed.

### Brief Description of Drawings

[FIG. 1] FIG. 1 is a block diagram schematically illustrating a configuration of an embodiment of a semiconductor inspection apparatus which is an example of an application of an electrical signal measurement apparatus.
[FIG.2] FIG. 2 is a block diagram illustrating an example of a specific configuration of a voltage application unit, an inspection optical system, and a light measurement unit.
[FIG.3] FIG. 3 is a block diagram schematically illustrating a configuration of a first embodiment of the electrical signal measurement apparatus including a signal conversion unit and a waveform measurement unit.
[FIG. 4] FIG. 4 is a diagram illustrating an example of a configuration of a light modulator in the signal conversion unit.
[FIG. 5] FIG. 5 is a diagram illustrating an example of a configuration of a streak tube in the waveform measurement unit.
[FIG. 6] FIG. 6 is a side view illustrating an example of a configuration of the waveform measurement unit.
[FIG. 7] FIG. 7 includes (a) a top view and (b) a side view illustrating an example of a configuration of an input optical system in the waveform measurement unit.
[FIG. 8] FIG. 8 includes (a) a diagram illustrating an optical image of an optical signal incident on a photocathode of the streak tube, and (b) a diagram illustrating a sweep of an electron image on a phosphor screen.
[FIG. 9] FIG. 9 is a diagram showing an example of a fluorescence image generated on the phosphor screen corresponding to the optical image of the optical signal input to the photocathode of the streak tube.
[FIG. 10] FIG. 10 includes (a) a diagram showing an example of a waveform image acquired in a state in which generation of the optical signal in the signal conversion unit is set to ON, and (b) a diagram showing an example of a base image acquired in a state in which generation of the optical signal is set to OFF.
[FIG. 11] FIG. 11 is a graph showing a measurement result of an electrical signal with an oscilloscope, and a measurement result with the electrical signal measurement apparatus illustrated in FIG. 3.
[FIG. 12] FIG. 12 includes diagrams illustrating a relationship of (a) an intensity of reflected light, (b) an intensity of the electrical signal, and (c) an intensity of the optical signal.
[FIG. 13] FIG. 13 includes (a) a top view and (b) a side view illustrating a first modification of a configuration of the input optical system of the waveform measurement unit.
[FIG. 14] FIG. 14 includes (a) a top view and (b) a side view illustrating a second modification of a configuration of the input optical system of the waveform measurement unit.
[FIG. 15] FIG. 15 includes (a) a top view and (b) a side view illustrating a third modification of a configuration of the input optical system of the waveform measurement unit.
[FIG. 16] FIG. 16 is a diagram illustrating a configuration of a second embodiment of the electrical signal measurement apparatus.
[FIG. 17] FIG. 17 is a diagram schematically illustrating a main sweep and a return sweep in the streak tube.
[FIG. 18] FIG. 18 is a diagram illustrating an example of setting of a measurement period and a phase of a sweep period in the streak tube.
[FIG. 19] FIG. 19 is a diagram illustrating a configuration of a third embodiment of the electrical signal measurement apparatus.
[FIG. 20] FIG. 20 is a diagram illustrating input of two types of optical signals to the photocathode in the configuration illustrated in FIG. 19.
[FIG. 21] FIG. 21 is a diagram illustrating a configuration of a fourth embodiment of the electrical signal measurement apparatus.

### Description of Embodiments

Hereinafter, embodiments of an electrical signal measurement apparatus and an electrical signal measurement method will be described in detail with reference to the accompanying drawings. In the description of the drawings, the same elements will be denoted by the same reference signs, and redundant description will be omitted. Further, the dimensional ratios in the drawings are not always coincident with those in the description.

In the following description, first, a configuration of a semiconductor inspection apparatus which is an example of a specific application of an electrical signal measurement apparatus will be described, and next, a configuration, an operation, and the like of the electrical signal measurement apparatus used in the semiconductor inspection apparatus will be described. In addition, the application of the electrical signal measurement apparatus described later is not specifically limited to the semiconductor inspection, and can be widely applied to measurement of a temporal waveform of an electrical signal in various configurations.

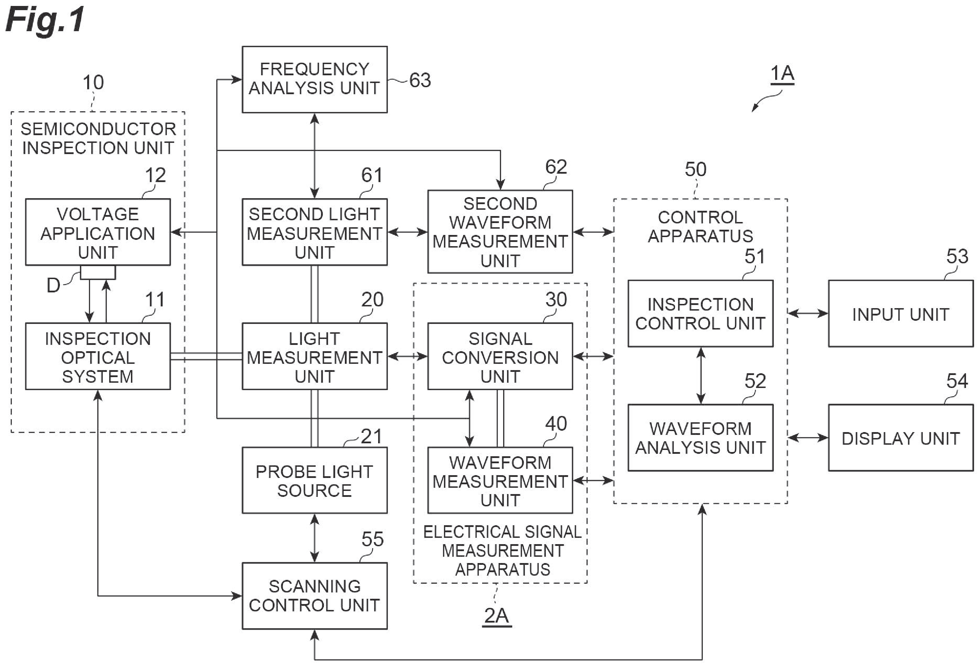

FIG. 1 is a block diagram schematically illustrating a configuration of an embodiment of a semiconductor inspection apparatus. A semiconductor inspection apparatus 1A according to the present embodiment is an apparatus for performing inspection by irradiating a semiconductor device D with probe light, and includes a semiconductor inspection unit 10, a light measurement unit 20, a probe light source 21, an electrical signal measurement apparatus 2A, a control apparatus 50, an input unit 53, a display unit 54, and a scanning control unit 55. In addition, the semiconductor inspection apparatus 1A further includes a second light measurement unit 61, a second waveform measurement unit 62, and a frequency analysis unit 63.

In addition, in each of the following diagrams, a double line illustrated between respective parts of the apparatus indicates a transmission path of light such as probe light, reflected light, measurement light, an optical signal, and the like. As for the above transmission path of light, it is preferable to use an optical fiber such as a single mode optical fiber. Further, as for the transmission path of light, a spatial transmission path by using a lens, a mirror, and the like may be used depending on a transmission condition. Further, each of a single line and an arrow line illustrated between respective parts of the apparatus indicates a transmission path of an electrical signal, a synchronization signal, a trigger signal, a control signal, and the like, or indicates an optical path of probe light and reflected light with respect to the semiconductor device D.

The semiconductor device D which is a device under test (DUT) to be an inspection target by the semiconductor inspection apparatus 1A illustrated in FIG. 1 can be set to arbitrary semiconductor device, and specific examples include an integrated circuit (IC) including a PN junction such as a transistor, and a large scale integration (LSI) device such as a logic device, a memory device, and an analog device.

Further, as the semiconductor device D, in addition, a mixed signal device obtained by combining the above components, or a power semiconductor device (a power device) such as a high current / high voltage MOS transistor, a bipolar transistor, an IGBT, or the like may be used. Further, the inspection of the semiconductor device D performed by the semiconductor inspection apparatus 1A utilizes, for example, techniques such as the EOP, the EOFM, and the like, and includes verification of operation states of respective parts of the device, identification of failure locations, and the like. Further, examples of the part of the semiconductor device D which is to be the inspection target include, for example, a transistor, a diode, a capacitor, a wiring line, and the like, to which a voltage is applied.

The semiconductor inspection unit 10 includes an inspection optical system 11 and a voltage application unit 12. The inspection optical system 11 irradiates the semiconductor device D which is the inspection target with probe light of a first wavelength supplied from the probe light source 21 via the light measurement unit 20. Further, the inspection optical system 11 outputs reflected light obtained by reflecting the probe light by the semiconductor device D to the light measurement unit 20.

The probe light irradiation on the semiconductor device D is, in general, performed from a rear surface side of the device, for example, from a Si substrate side. Therefore, as the probe light, light of a wavelength capable of being transmitted through silicon is used. In this case, it is preferable to set the first wavelength of the probe light within a wavelength range of 1050 nm or more and 5000 nm or less. As the above probe light, specifically, for example, light of a wavelength of 1.3 µm can be used.

The probe light supplied from the probe light source 21 may be coherent light, or may be incoherent light. Specific examples of the probe light source 21 include a laser light source, a super luminescent diode (SLD), an amplified spontaneous emission (ASE) light source, a light emitting diode (LED), and the like.

The voltage application unit 12 applies a test pattern in which a voltage changes over time repeatedly with a predetermined test period to the semiconductor device D. In this case, in the semiconductor device D to which the test pattern is applied, states of respective parts of the device change over time with the test period of the voltage change. The light measurement unit 20 supplies the probe light which is output from the probe light source 21 to the inspection optical system 11, and further, inputs the reflected light from the semiconductor device D which is output from the inspection optical system 11. An intensity of the reflected light from the semiconductor device D changes over time with the test period according to a temporal change of a state of the semiconductor device D.

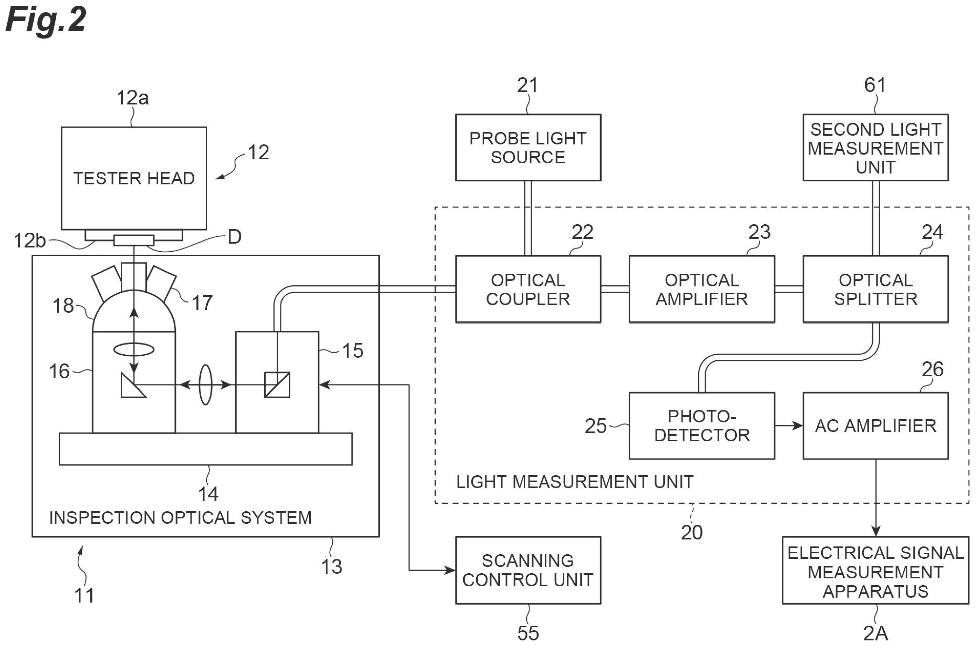

FIG. 2 is a block diagram illustrating an example of a specific configuration of the voltage application unit 12, the inspection optical system 11, and the light measurement unit 20. In the present configuration example, the voltage application unit 12 includes a tester head 12a of a semiconductor tester (an LSI tester) and a test board 12b. The tester head 12a mounts the semiconductor device D via the test board 12b, and repeatedly applies with the test period described above, to the semiconductor device D, the test pattern including a predetermined operation pulse signal and for driving the semiconductor device D.

The tester head 12a includes, for example, a pulse generator for generating the operation pulse signal for driving a transistor and the like included in the semiconductor device D, a tester unit for inputting the operation pulse signal to the semiconductor device D, and a power source. Further, the test board 12b is a semiconductor substrate for mounting the semiconductor device D. The test board 12b includes a peripheral chip, a circuit, a terminal, and the like necessary for the operation of the semiconductor device D.

The inspection optical system 11 includes a stage 14, a scanning optical system 15, an imaging optical system 16, and an objective lens 17. Further, the scanning optical system 15, the imaging optical system 16, and the objective lens 17 are placed on the stage 14, and arranged in a dark box 13. The objective lens 17 is provided between the imaging optical system 16 and the semiconductor device D. In the present configuration example, a plurality of objective lenses are provided as the objective lens 17, and these objective lenses are switchable by using a turret 18. As the plurality of objective lenses 17, for example, an objective lens of a low magnification (for example, 5×) and an objective lens of a high magnification (for example, 50×) are provided.

The scanning optical system 15 guides the probe light input from the probe light source 21 via the light measurement unit 20 and an optical fiber to the imaging optical system 16. An output end of the probe light in the optical fiber is preferably of an APC type in order to reduce reflection of the light. The scanning optical system 15 has an optical scanner including an optical scanning element such as, for example, a galvano mirror, a MEMS mirror, or the like, and scans and sets an irradiation position of the probe light with respect to the semiconductor device D based on control by the scanning control unit 55.

The imaging optical system 16 guides the probe light input from the scanning optical system 15 to the objective lens 17 along a predetermined optical path. The objective lens 17 focuses the probe light and irradiates the irradiation position which is set in the semiconductor device D with the probe light. Further, the reflected light (return light) generated by irradiating the semiconductor device D with the probe light is input to the light measurement unit 20 via the objective lens 17, the imaging optical system 16, the scanning optical system 15, and the optical fiber. A wavelength of the above reflected light is the first wavelength as the wavelength of the probe light. A solid immersion lens may be provided between the objective lens 17 and the semiconductor device D as needed.

In the reflected light from the semiconductor device D, reflectance and absorptance for the probe light slightly change (on the order of several tens of ppm/V) due to an electric field and heat generated in a measurement target point at the irradiation position of the probe light, and due to changes in carrier density caused thereby, and as a result, a small temporal change occurs in the intensity of the reflected light. By measuring the temporal change of the intensity of the reflected light described above, the inspection of the semiconductor device D can be performed.

The light measurement unit 20 includes an optical coupler 22, an optical amplifier 23, an optical splitter 24, a photodetector 25, and an AC amplifier 26. The optical coupler 22 is optically coupled to the probe light source 21, the optical amplifier 23, and the scanning optical system 15 via optical fibers, and outputs the probe light input from the probe light source 21 to the scanning optical system 15, and further, outputs the reflected light from the semiconductor device D input from the scanning optical system 15 to the optical amplifier 23. Further, for connection between the optical coupler 22 and the scanning optical system 15, for example, an FC adapter for APC is used.

As the optical coupler 22, specific examples include a PBS type optical coupler, a circulator type optical coupler, and the like. In the case in which the optical coupler 22 is the PBS type optical coupler, a λ/4 wave plate may be provided in the scanning optical system 15. Further, in the case in which the optical coupler 22 is the circulator type optical coupler, a λ/2 wave plate may be provided in the scanning optical system 15. In the scanning optical system 15, a Faraday rotator may be provided in place of the wave plate described above. Further, an optical splitter may be used as the optical coupler 22.

The optical amplifier 23 amplifies the intensity of the reflected light from the semiconductor device D input from the optical coupler 22 within a range in which gain saturation does not occur and within a range in which the photodetector 25 provided at the subsequent stage does not saturate, and outputs the reflected light after the amplification to the optical splitter 24. As the optical amplifier 23, specific examples include a semiconductor optical amplifier, an optical fiber amplifier, a solid optical amplifier (SOA), a tapered optical amplifier, a booster optical amplifier, and the like. Further, as the optical amplifier 23, an optical amplifier using a crystal, gas, liquid, or the like as an amplification medium may also be used.

The optical splitter 24 is optically coupled to the photodetector 25, the second light measurement unit 61, and the optical amplifier 23 via optical fibers, and outputs the reflected light input from the optical amplifier 23 to the photodetector 25 and the second light measurement unit 61 at a predetermined splitting ratio. As the optical splitter 24, specifically, for example, a 90 : 10 optical splitter can be used. In this case, the light from the optical amplifier 23 is split by the optical splitter 24 at a splitting ratio of 90 : 10 for the photodetector 25 and the second light measurement unit 61. Further, for connection between the optical splitter 24 and the second light measurement unit 61, for example, an FC connector is used.

The photodetector 25 detects the reflected light after the amplification input from the optical splitter 24, and outputs an electrical signal (a detection signal) indicating the detection result. The electrical signal output from the photodetector 25 has a temporal waveform according to the temporal change of the intensity of the reflected light from the semiconductor device D. As the photodetector 25, for example, it is preferable to use a PIN photodiode (PIN-PD) capable of performing detection operation at high speed.

In the case in which the high speed optical sensor such as the PIN-PD is used as the photodetector 25, input is basically performed via a single mode optical fiber. Therefore, it is preferable that the input optical fiber, the optical coupler, and the like be configured entirely by combinations of single mode optical fibers. In addition, the above light guide system may be configured by using an optical system using a combination of a half mirror, a polarizing beam splitter, a collimator, and the like. Further, as the photodetector 25, in addition to the PIN-PD, other photodiodes such as an avalanche photodiode (APD), a photomultiplier tube, and the like may be used.

The AC amplifier 26 amplifies an AC component of the detection signal input as the electrical signal from the photodetector 25, and outputs the electrical signal after the amplification to the electrical signal measurement apparatus 2A. By the above signal amplification in the AC amplifier 26, a temporal change component of an intensity in the detection signal is extracted, and further, an offset level of the electrical signal before input to the electrical signal measurement apparatus 2A is appropriately adjusted and set. The above operation of offset reset will further be described later.

Referring again to FIG. 1. The electrical signal measurement apparatus 2A includes a signal conversion unit 30 and a waveform measurement unit 40. The signal conversion unit 30 converts the electrical signal input from the AC amplifier 26 of the light measurement unit 20 as a measurement target into an optical signal for signal waveform measurement, and outputs the optical signal after the conversion to the waveform measurement unit 40. The waveform measurement unit 40 performs measurement for a temporal waveform of the optical signal input from the signal conversion unit 30, and outputs the measurement result to the control apparatus 50. In addition, a configuration of the electrical signal measurement apparatus 2A will specifically be described later.

The control apparatus 50 includes an inspection control unit 51 and a waveform analysis unit 52. By controlling operations of respective parts of the apparatus of the semiconductor inspection unit 10, the light measurement unit 20, the probe light source 21, the scanning control unit 55, the electrical signal measurement apparatus 2A, and the like, the inspection control unit 51 controls and performs the inspection of the semiconductor device D in the semiconductor inspection apparatus 1A and the measurement of the temporal waveform of the electrical signal in the electrical signal measurement apparatus 2A. The waveform analysis unit 52 obtains the temporal waveform of the electrical signal based on the measurement result of the temporal waveform of the optical signal input from the waveform measurement unit 40 of the electrical signal measurement apparatus 2A. In the case of the semiconductor inspection apparatus 1A described above, the electrical signal for obtaining the temporal waveform is the electrical signal generated in the light measurement unit 20 according to the temporal change of the intensity of the reflected light.

Further, in the configuration illustrated in FIG. 1, an input unit (an input device) 53 and a display unit (a display device) 54 are provided for the control apparatus 50. The input unit 53 includes, for example, a keyboard, a mouse, and the like, and is used for input of information and the like necessary for performing the semiconductor inspection in the semiconductor inspection apparatus 1A, and the electrical signal measurement and the waveform analysis in the electrical signal measurement apparatus 2A. The display unit 54 includes, for example, a liquid crystal display, and is used for display of the inspection result of the semiconductor device D, the result of the waveform analysis of the electrical signal, and the like.

The control apparatus 50 can be configured by, specifically, for example, a computer including a CPU as a processing unit, and a ROM, a RAM, and an external storage device as a storage unit. In this case, the computer functions as the inspection control apparatus (the measurement control apparatus) and the waveform analysis apparatus. Further, the inspection control unit (the measurement control unit) 51 and the waveform analysis unit 52 may be configured by using separate computers, or may be configured by using a single computer.

In the semiconductor inspection apparatus 1A illustrated in FIG. 1, the second light measurement unit 61, the second waveform measurement unit 62, and the frequency analysis unit 63 are parts of the apparatus which perform the EOP and the EOFM by using the methods similar to those of the conventional inspection apparatus. The second light measurement unit 61 includes, for example, a photodetector such as an avalanche photodiode or the like, and an amplifier. The second waveform measurement unit 62 is configured by using, for example, a digitizing board, a digital oscilloscope, or the like. The frequency analysis unit 63 is configured by using, for example, a spectrum analyzer for EOFM image acquisition, a lock-in amplifier, or the like.

In the above configuration, the electrical signal measurement apparatus 2A functions as a high speed digitizing unit, and the second waveform measurement unit 62 functions as a low speed digitizing unit. Further, from the voltage application unit 12 of the semiconductor inspection unit 10, a synchronization signal of a sine wave shape, a trigger signal of a rectangular wave shape, and the like are output, and the synchronization signal and the trigger signal described above are supplied to respective parts of the apparatus of the electrical signal measurement apparatus 2A, the second waveform measurement unit 62, the frequency analysis unit 63, and the like as needed. In addition, the synchronization signal is not limited to the signal of the sine wave shape described above, and may be, for example, a signal of a rectangular wave shape or the like.

Next, the configuration and the operation of the electrical signal measurement apparatus 2A used in the semiconductor inspection apparatus 1A illustrated in FIG. 1 will be described.

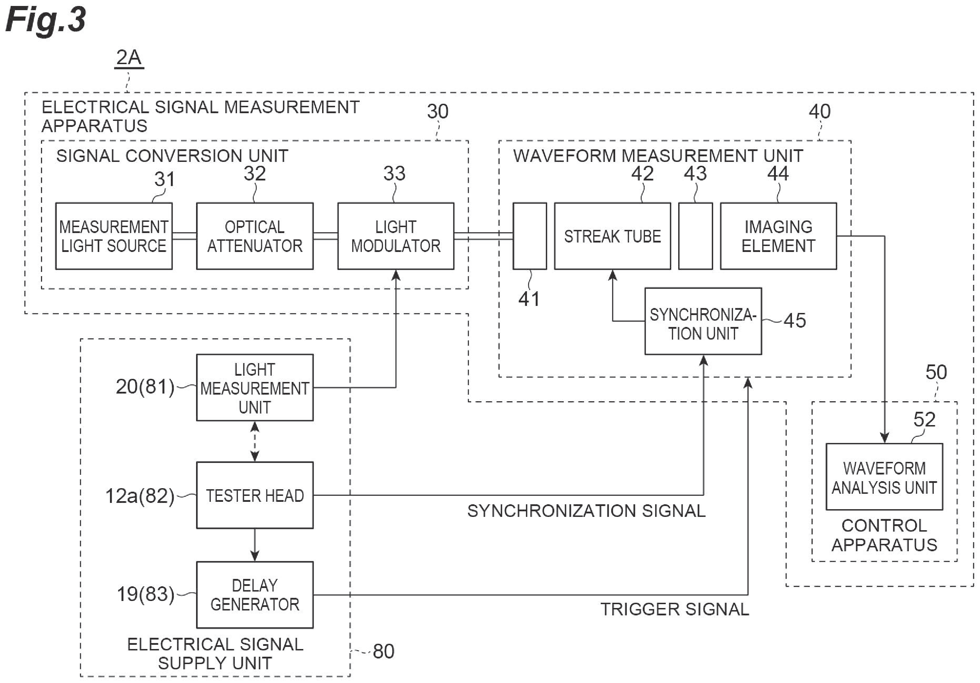

FIG. 3 is a block diagram schematically illustrating a configuration of a first embodiment of the electrical signal measurement apparatus including the signal conversion unit 30 and the waveform measurement unit 40. The electrical signal measurement apparatus 2A according to the present embodiment is configured as a streak oscilloscope by using a streak camera (for example, see Patent Documents 3 and 4). Further, as illustrated in FIG. 3, the waveform analysis unit (the waveform analysis apparatus) 52 of the control apparatus 50 is included in the electrical signal measurement apparatus 2A as needed.

In addition, in FIG. 3, the light measurement unit 20, the tester head 12a, and a delay generator (DG) 19 connected to the tester head 12a are illustrated with respect to the electrical signal measurement apparatus 2A, and these components are referred to as an electrical signal supply unit 80 for the sake of convenience. In the electrical signal supply unit 80, the light measurement unit 20 functions as an electrical signal output unit 81, the tester head 12a functions as a synchronization signal output unit 82, and the delay generator 19 functions as a trigger signal output unit 83. The delay generator 19 adjusts a delay time, a pulse width, and the like of the signal supplied from the tester head 12a, and outputs the adjusted signal as the trigger signal.

Further, as described above, the application of the electrical signal measurement apparatus 2A according to the present embodiment is not limited to the semiconductor inspection apparatus 1A, and can be applied to the measurement of the temporal waveform of the electrical signal in various configurations. In the above case, the electrical signal output unit 81, the synchronization signal output unit 82, and the trigger signal output unit 83 in the electrical signal supply unit 80 are appropriately set according to a specific measurement target. Further, the synchronization signal output unit 82 and the trigger signal output unit 83 may not be provided if unnecessary.

The signal conversion unit 30 includes a measurement light source 31, an optical attenuator 32, and a light modulator 33. The measurement light source 31 supplies measurement light of a predetermined wavelength. Further, in the case in which it is applied to the semiconductor inspection apparatus 1A as described above, the measurement light source 31 supplies the measurement light of a second wavelength different from the first wavelength of the probe light for the semiconductor inspection. The above measurement light is continuous light which becomes the basis of the optical signal input to the waveform measurement unit 40. As the measurement light, light having a wavelength which can be used in a modulation operation by the light modulator 33 and can be used for waveform measurement by a streak tube 42 in the waveform measurement unit 40 described later is used.

In this case, it is preferable to set the predetermined wavelength of the measurement light within a wavelength range of 115 nm or more and 1600 nm or less, in consideration of a sensitivity distribution and the like on a photocathode used in the streak tube 42, and further, in order to obtain sufficient sensitivity, it is further preferable to set within a wavelength range of 200 nm or more and less than 1050 nm. As the above measurement light, specifically, for example, light of a wavelength of 850 nm or a wavelength of 780 nm can be used. Further, in order to suppress deterioration in temporal resolution due to dispersion in an optical fiber, it is preferable to use narrow band light as the measurement light.

As the measurement light source 31, specific examples include a laser light source, a super luminescent diode (SLD), a light emitting diode (LED), and the like. It is preferable to select the measurement light source 31 to be actually used according to a type of a modulator which is used as the light modulator 33. The measurement light output from the measurement light source 31 is attenuated and adjusted with respect to an intensity (a light amount) by the optical attenuator 32, and is then input to the light modulator 33 as the continuous light.

The electrical signal from the light measurement unit 20 is input to the light modulator 33 as a modulation control signal. The light modulator 33 intensity modulates the measurement light supplied from the measurement light source 31 based on the electrical signal input from the light measurement unit 20, and outputs the measurement light after the modulation as the optical signal having the temporal waveform corresponding to the temporal waveform of the electrical signal. As the light modulator 33, a device having a configuration capable of performing light intensity modulation in an analog way is used.

Specific examples of the light modulator 33 include an electro-optic (EO) modulator, an acousto-optic (AO) modulator, a magnetooptic (MO) modulator, a Pockels cell, and the like. In addition, out of the above devices, the Pockels cell requires a voltage of about several hundred V, and thus, there is a problem in the modulation with a weak electrical signal. Further, the AO modulator is limited in bandwidth to about several hundred MHz. Further, the MO modulator requires a relatively large magnetic field (current).

In consideration of the above points, it is preferable to use the EO modulator as the light modulator 33. By using the above configuration, the intensity modulation of the measurement light by a high speed electrical signal can be suitably realized. In addition, in the case in which the EO modulator, the AO modulator, or the MO modulator is used as the light modulator 33, it is preferable to use a laser light source as the measurement light source 31. Further, in the case in which the Pockels cell is used as the light modulator 33, it is preferable to use an SLD or an LED as the measurement light source 31.

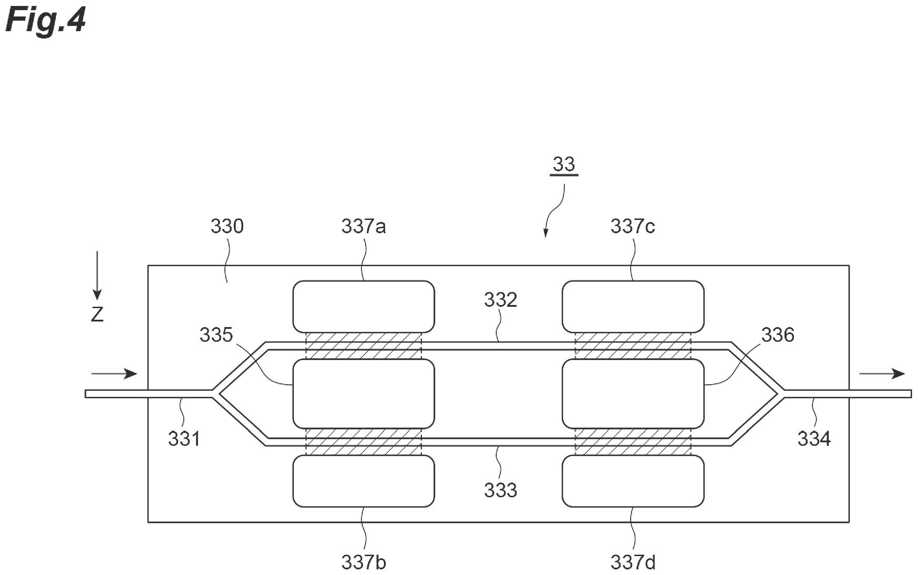

FIG. 4 is a diagram illustrating an example of a configuration of the light modulator 33 in the signal conversion unit 30. In the present configuration example, the light modulator 33 includes an EO crystal 330, optical waveguides 331 to 334 formed on the crystal 330, an RF electrode 335, a bias electrode 336, and ground electrodes 337a to 337d, and is configured as the EO modulator capable of performing the light intensity modulation. As the EO crystal 330, specifically, for example, lithium niobate (LiNbO₃) can be used.

In the configuration illustrated in FIG. 4, on the EO crystal 330 of a rectangular shape, the input optical waveguide 331 is provided on the left side in the diagram, and the output optical waveguide 334 is provided on the right side. The input optical waveguide 331 is split into the first splitting optical waveguide 332 and the second splitting optical waveguide 333 via a 50 : 50 optical coupler. Further, the first and second splitting optical waveguides 332 and 333 are combined again via a 50 : 50 optical coupler, and coupled to the output optical waveguide 334.

The measurement light of the modulation target input from the measurement light source 31 to the input optical waveguide 331 is split into the first and second splitting optical waveguides 332 and 333 by the input side optical coupler. Further, the split light components guided respectively through the first and second splitting optical waveguides 332 and 333 interfere with each other at the time of combining by the output side optical coupler, and the combined light is output from the output optical waveguide 334 as interference light having a predetermined intensity. The above interference light output from the output optical waveguide 334 becomes the optical signal input to the waveform measurement unit 40 as the measurement target of the temporal waveform.

Between the first and second splitting optical waveguides 332 and 333, the RF electrode 335 is provided on the input side, and the bias electrode 336 is provided on the output side. The ground electrode 337a is provided for the RF electrode 335 with the first splitting optical waveguide 332 interposed therebetween, and the ground electrode 337b is provided for the RF electrode 335 with the second splitting optical waveguide 333 interposed therebetween. Further, the ground electrode 337c is provided for the bias electrode 336 with the first splitting optical waveguide 332 interposed therebetween, and the ground electrode 337d is provided for the bias electrode 336 with the second splitting optical waveguide 333 interposed therebetween.

In the above configuration, each of regions between the electrodes indicated by hatching in the diagram is a region in which an electric field is applied to the optical waveguide by voltage application to the RF electrode 335 or the bias electrode 336. When the electric field is applied to the EO crystal 330, a refractive index in the optical waveguide formed in the electric field applied region changes. As a result, an optical path difference between the first and second splitting optical waveguides 332 and 333 changes, and the intensity of the interference light output from the output optical waveguide 334 changes.

The electrical signal from the light measurement unit 20 which is used for the intensity modulation of the measurement light is applied to the RF electrode 335 provided in the input side on the EO crystal 330. By using the above configuration, the conversion of the electrical signal into the optical signal by the light modulator 33 is performed. Further, the voltage application to the bias electrode 336 is used for performing phase adjustment of interference of the light, and for example, is used for performing offset adjustment in the signal conversion from the electrical signal to the optical signal, as described later.

In the light modulator 33 using the EO modulator as described above, a polarization direction of the light to be modulated is determined, and further, an interference distance longer than an interference unit in the light modulator 33 is required, and thus, it is preferable to use laser light as the measurement light which is the modulation target. Further, in particular, in the case in which a Z direction in the crystal is a vertical direction in the diagram, reversing a direction of the electric field applied to the Z axis reverses a change amount of the refractive index, and thus, the light can be modulated at higher speed with lower voltage. In addition, it is also possible to use, as the light modulator 33, a thin film EO modulator utilizing a photonic integrated circuit (PIC).

Referring again to FIG. 3. The waveform measurement unit 40 includes an input optical system 41, a streak tube 42, an output optical system (an imaging optical system) 43, an imaging element 44, and a synchronization unit 45, and is configured as the streak camera. Further, the trigger signal of the rectangular wave shape from the delay generator 19 (the trigger signal output unit 83) is input to the waveform measurement unit 40 including the streak tube 42, and further, the synchronization signal of the sine wave shape or the like from the tester head 12a (the synchronization signal output unit 82) is input via the synchronization unit (synchronization circuit) 45.

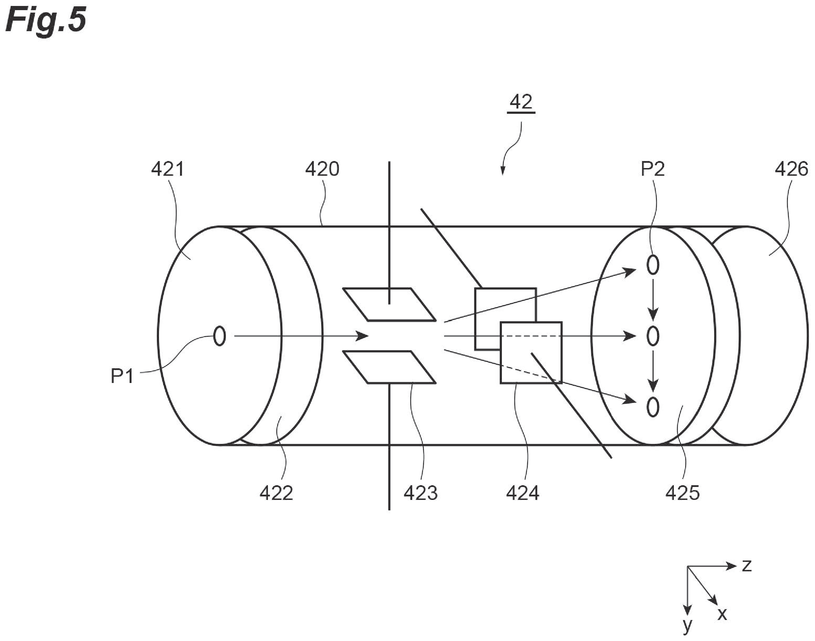

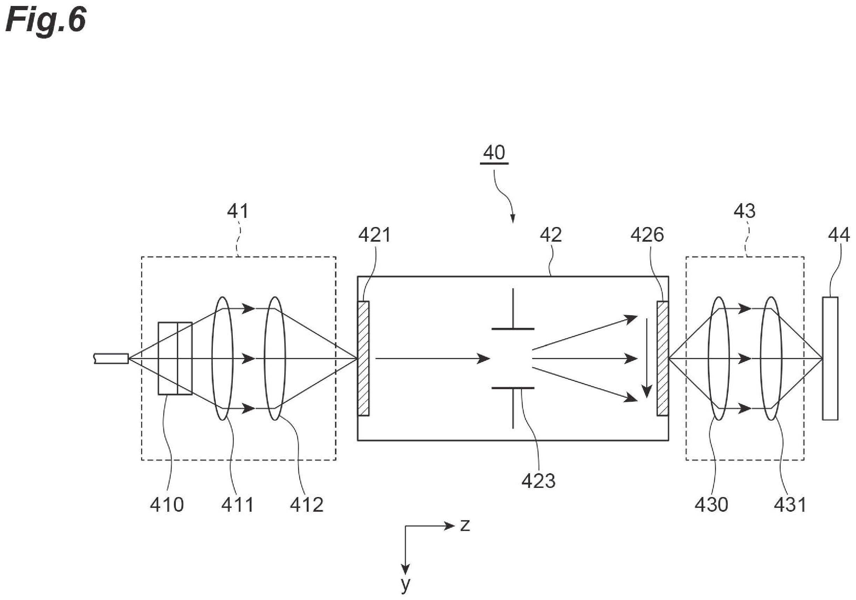

The configuration of the streak camera of the waveform measurement unit 40 including the streak tube 42 will be described. FIG. 5 is a perspective view illustrating an example of a configuration of the streak tube 42. Further, FIG. 6 is a side view illustrating an example of a configuration of the waveform measurement unit 40 including the streak tube 42. In the present configuration example, the streak tube 42 includes an outer tube 420, a photocathode 421, an accelerating electrode 422, vertical sweep electrodes 423, horizontal sweep electrodes 424, a micro channel plate (MCP) 425, and a phosphor screen 426. Further, in the streak tube 42, the MCP 425 may not be provided.

In addition, in each of the following diagrams, as illustrated by an xyz orthogonal coordinate system in FIG. 5, for the configuration of the streak tube 42, and the input optical system 41 and the output optical system 43, a propagation direction of the optical signal and electrons is defined as a z axis direction, a sweep direction of the electrons in the streak tube 42 orthogonal to the z axis direction is defined as a y axis direction, and a direction orthogonal to both the z axis direction and the y axis direction is defined as an x axis direction. Further, FIG. 6 is a side view as seen from the x axis direction illustrating the configuration of the waveform measurement unit 40.

In the configuration illustrated in FIG. 5, with respect to the outer tube 420 extending in the z axis direction, the photocathode 421 is provided on the input side, and the phosphor screen 426 is provided on the output side opposite to the photocathode 421. The optical signal from the signal conversion unit 30 is incident on the photocathode 421 via the input optical system 41, and forms an optical image P1 on the photocathode 421. The photocathode 421 generates electrons (photoelectrons) in response to input of the optical signal. In this case, the number of electrons generated by the photocathode 421 is according to the intensity of the optical signal at each time. The electrons emitted from the photocathode 421 are accelerated in the z axis direction by the accelerating electrode 422 in the outer tube 420.

In the outer tube 420 between the photocathode 421 and the phosphor screen 426, in order from the photocathode 421 side, the vertical sweep electrodes 423, the horizontal sweep electrodes 424, and the MCP 425 described above are provided. The vertical sweep electrodes 423 sweep the electrons from the photocathode 421 in a predetermined sweep direction (the y axis direction) with a sweep period which is set according to the test period in the semiconductor inspection unit 10 by application of a sweep voltage of a predetermined pattern. The electrons swept by the sweep electrodes 423 are multiplied by the MCP 425, and incident on the phosphor screen 426. A size of the phosphor screen 426 is, for example, ϕ18 mm.

Further, in this case, an electron image P2 formed on the phosphor screen 426 moves in the y axis direction with time due to the sweep of the electrons by the sweep electrodes 423. By using the above configuration, on the phosphor screen 426, with the y axis direction as the time axis, a fluorescence image indicating the temporal waveform of the optical signal input to the photocathode 421 is generated. In addition, in FIG. 5, for ease of illustration, movement of the electron image P2 in the y axis direction is schematically illustrated on an incident surface of the MCP 425. Further, the horizontal sweep electrodes 424 are used in the case in which it is necessary to sweep and move the electron image P2 in the x axis direction orthogonal to the normal sweep direction.

As illustrated in FIG. 6, the fluorescence image generated on the phosphor screen 426 of the streak tube 42 is input to the imaging element 44 via the output optical system 43. The imaging element 44 captures the fluorescence image generated on the phosphor screen 426, and outputs a waveform image which is a two-dimensional image. As the imaging element 44, a two-dimensional imaging element such as a CMOS imaging element or a CCD imaging element is used, and specifically, for example, a CMOS camera having the number of pixels of 2048 × 2048 and a pixel size of 6.5 µm × 6.5 µm is used. Further, in the configuration illustrated in FIG. 6, the output optical system 43 is configured by lenses 430 and 431.

The waveform image acquired by the imaging element 44, similarly to the fluorescence image on the phosphor screen 426, is an image indicating the temporal waveform of the optical signal input to the waveform measurement unit 40, with the y axis direction as the time axis. The waveform analysis unit 52 of the control apparatus 50 (see FIG. 3) obtains the temporal waveform of the electrical signal corresponding to the temporal waveform of the optical signal based on the waveform image described above output from the imaging element 44. The above temporal waveform of the electrical signal corresponds to the temporal change of the intensity of the reflected light from the semiconductor device D in the semiconductor inspection unit 10. Therefore, by referring to the temporal waveform of the electrical signal acquired by the waveform analysis unit 52, the inspection of the semiconductor device D can be performed.

Further, in order to accurately measure the small temporal change of the intensity of the reflected light in the semiconductor inspection unit 10, the optical signal from the signal conversion unit 30 may be repeatedly input to the waveform measurement unit 40 over a plurality of periods, and the fluorescence image may be generated on the phosphor screen 426 of the streak tube 42 in which the temporal waveforms of the optical signal of the plurality of periods with respect to the test period are integrated. In this case, the waveform image acquired by the imaging element 44 similarly becomes an image in which the temporal waveforms of the optical signal of the plurality of periods are integrated. The above integration of the temporal waveform of the optical signal can be similarly suitably used in configurations other than the semiconductor inspection, for example, in the case in which the electrical signal of the measurement target is a weak signal, and the electrical signal is an electrical signal in which the temporal waveform repeats with a predetermined period, or the like.

In order to suitably perform the measurement of the the temporal waveform of the electrical signal and the inspection of the semiconductor device D as described above, the streak camera of the waveform measurement unit 40 controls the measurement operation for the temporal waveform of the optical signal based on the synchronization signal or the trigger signal supplied from the voltage application unit 12. Specifically, the waveform measurement unit 40 has two measurement modes of a single sweep mode and a synchro scan mode for the measurement of the temporal waveform of the optical signal.

In the single sweep mode, the waveform measurement unit 40 performs single shot measurement in synchronization with the trigger signal of the rectangular wave shape from the tester head 12a or the delay generator 19. In this case, the sweep voltage which is applied to the sweep electrodes 423 is, for example, a voltage pattern which changes linearly. Further, in this case, the test period of the voltage application in the semiconductor tester can be freely set. In addition, in the single sweep mode, the single shot measurement may be repeatedly performed a plurality of times, and the integration of the temporal waveforms may be performed.

In the synchro scan mode, the waveform measurement unit 40 performs measurement for integrating the temporal waveforms of the plurality of periods in synchronization with the synchronization signal of the sine wave shape from the tester head 12a. In this case, the sweep voltage which is applied to the sweep electrodes 423 is controlled by the synchronization unit 45, and is, for example, a voltage pattern of a sine wave shape similar to the synchronization signal. In the above mode, for example, high temporal accuracy of 800 fs or less can be realized. In addition, in this case, the test period in the semiconductor tester is limited to an integer multiple of the period of the synchronization signal.

The input condition of the optical signal to the photocathode 421 of the streak tube 42, and the configuration of the input optical system 41 provided before the streak tube 42 will be described. In the above configuration, shot noise based on a light amount of the optical signal input to the streak tube 42 determines a noise floor of the measurement. In this case, in order to reduce a ratio of the shot noise, it is preferable to increase the light amount, however, an upper limit exists for the input light amount density for the photocathode 421. Further, in the case of performing the integration measurement of the temporal waveform of the optical signal a large number of times and the like, degradation of the photocathode due thereto also becomes a problem.

In consideration of the above points, in order to reduce the input light amount density to the photocathode and suppress degradation of the photocathode, it is preferable that the input optical system 41 input the optical signal to the photocathode 421 as a line-shaped optical image extending in a direction intersecting with the sweep direction (the y axis direction) in the streak tube 42. By using the above configuration, as compared with the case in which the optical signal is input as the point-shaped optical image P1 as illustrated in FIG. 5, the input light amount density can be reduced. In addition, in this case, it is preferable to set an image formation direction of the line-shaped optical image in a direction (the x axis direction) orthogonal to the sweep direction.

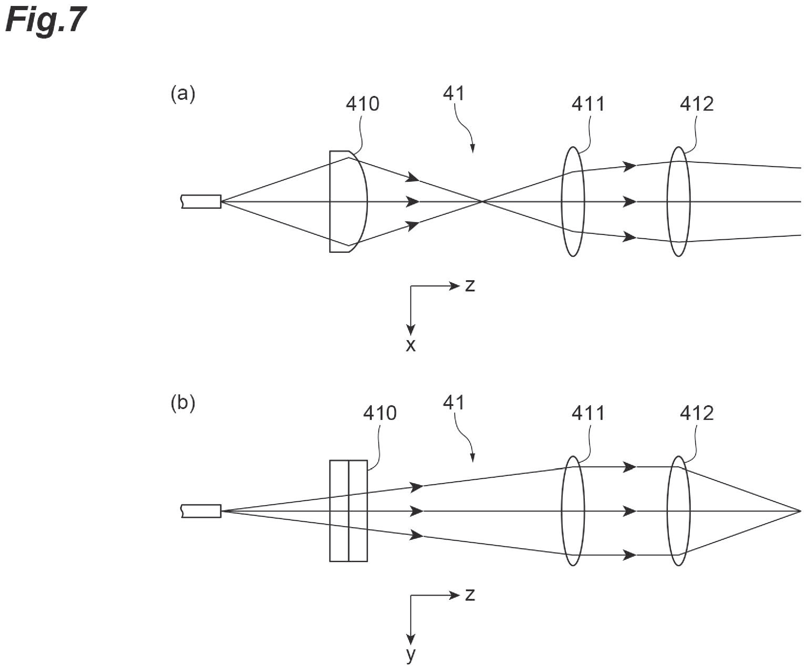

FIG. 7 includes diagrams illustrating an example of a configuration of the input optical system 41 in the waveform measurement unit 40. In FIG. 7, (a) in FIG. 7 illustrates a top view as seen from the y axis direction, and (b) in FIG. 7 illustrates a side view as seen from the x axis direction. Further, a lens configuration in the input optical system 41 illustrated in FIG. 7 is a configuration similar to the lens configuration schematically illustrated in FIG. 6.

The input optical system 41 illustrated in FIG. 6 and FIG. 7 is configured, in order from the input side of the optical signal from the signal conversion unit 30 (an optical fiber end side where the optical signal is output), by a cylindrical lens 410, a lens 411, and a lens 412. As described above, by using the cylindrical lens 410 in the input optical system 41, as indicated by a spread of light rays in FIG. 7, the line-shaped optical image can be formed on the photocathode 421.

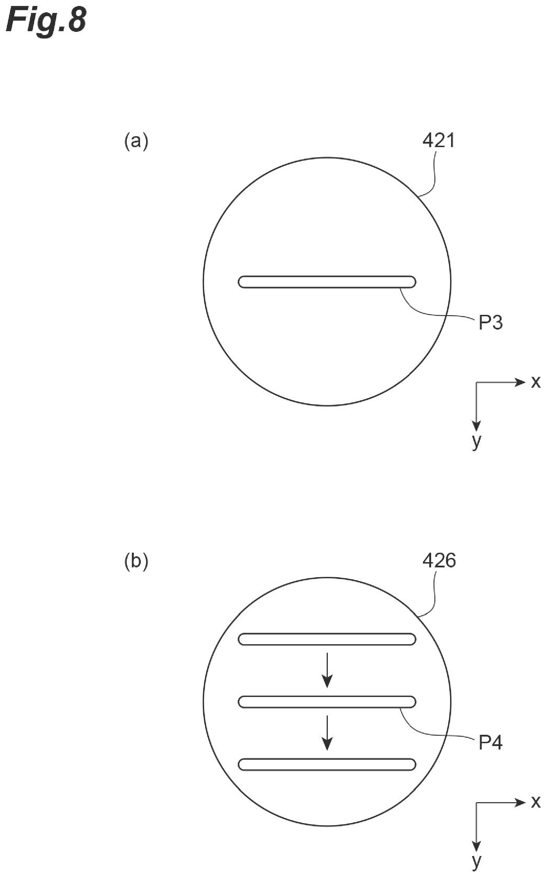

FIG. 8 includes diagrams schematically illustrating the optical image and the electron image formed in the streak tube 42. In FIG. 8, (a) in FIG. 8 is a diagram illustrating an optical image P3 of the optical signal incident on the photocathode 421 of the streak tube 42, and (b) in FIG. 8 is a diagram illustrating a sweep of an electron image P4 on the phosphor screen 426. Further, the optical image P3 and the electron image P4 illustrated in FIG. 8 are formed in the configuration by using the input optical system 41 illustrated in FIG. 7.

As illustrated in (a) in FIG. 8, the optical signal is input to the photocathode 421 as the line-shaped optical image P3 extending in the x axis direction. Further, as illustrated in (b) in FIG. 8, on the phosphor screen 426, the line-shaped electron image P4 extending in the x axis direction corresponding to the optical image P3 is formed, and by sweeping the above electron image P4 in the y axis direction, the fluorescence image indicating the temporal waveform of the optical signal is generated.

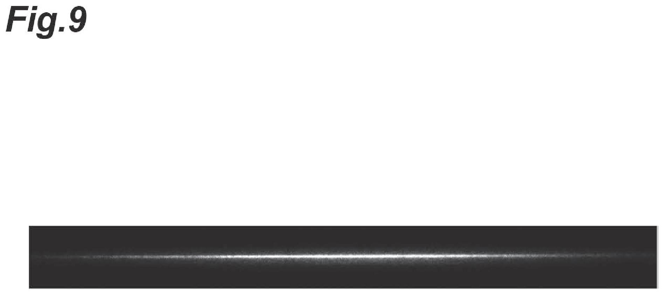

FIG. 9 is an image showing an example of the fluorescence image generated on the phosphor screen 426 corresponding to the line-shaped optical image of the optical signal which is input to the photocathode 421 of the streak tube 42. In this case, without performing the sweep of the electrons by the sweep electrodes 423, the fluorescence image corresponding to the line-shaped electron image is measured as is. Further, in the line-shaped optical image on the photocathode 421 corresponding to the fluorescence image shown in FIG. 9, a length in the x axis direction is about 5 mm, and a width in the y axis direction is about 15 µm.

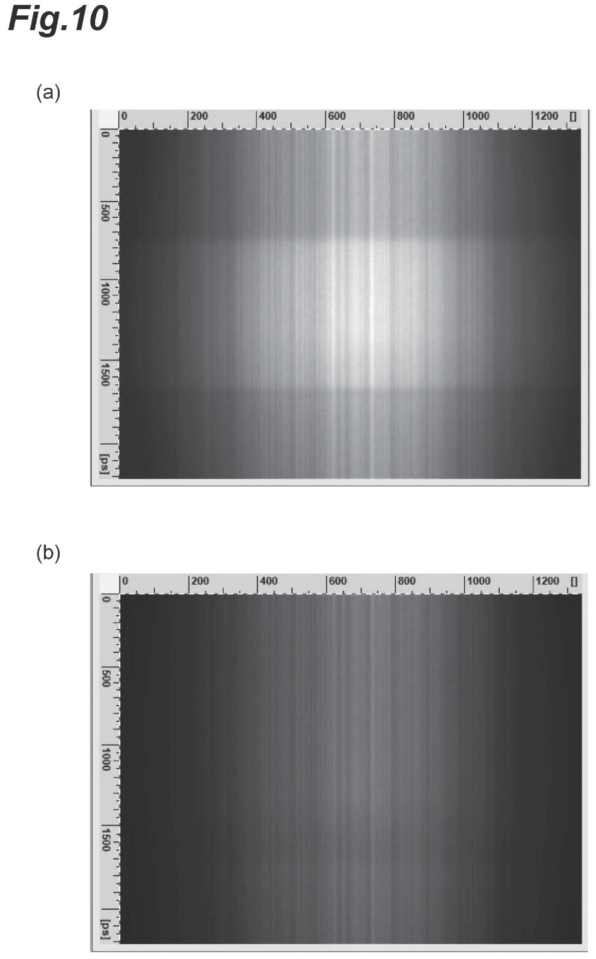

Further, FIG. 10 includes diagrams showing an example of an image obtained by capturing the fluorescence image generated on the phosphor screen 426 with the imaging element 44 in a normal measurement in which the electrons are swept by the sweep electrodes 423. In FIG. 10, (a) in FIG. 10 shows the waveform image acquired in a state in which the generation of the optical signal in the signal conversion unit 30 is set to ON, and (b) in FIG. 10 shows a base image (a background image) acquired in a state in which the generation of the optical signal is set to OFF. In the waveform image of (a) in FIG. 10, the fluorescence image obtained by sweeping the line-shaped electron image is measured.

An electrical signal measurement method performed by using the electrical signal measurement apparatus 2A illustrated in FIG. 3 includes a signal conversion step, a waveform measurement step, and a waveform analysis step. In the signal conversion step, in the signal conversion unit 30, based on the electrical signal input as the measurement target of the temporal waveform, the measurement light is intensity modulated by the light modulator 33, and the measurement light after the modulation is output as the optical signal having the temporal waveform corresponding to the temporal waveform of the electrical signal.

In the waveform measurement step, in the waveform measurement unit 40, by using the streak tube 42, the imaging element 44, and the like, the measurement is performed for the temporal waveform of the optical signal output from the signal conversion unit 30, and the obtained waveform image is output. Further, in this case, the input optical system 41 inputs the optical signal to the photocathode 421 as the line-shaped optical image extending in the direction intersecting with the sweep direction of the electrons in the streak tube 42. In the waveform analysis step, in the waveform analysis unit 52 of the control apparatus 50, the temporal waveform of the electrical signal is obtained based on the waveform image which is output from the waveform measurement unit 40.

The effects of the electrical signal measurement apparatus 2A according to the above embodiment, and the electrical signal measurement method which is performed by using the apparatus will be described.

In the electrical signal measurement apparatus 2A and the electrical signal measurement method illustrated in FIG. 3 to FIG. 8, the electrical signal which is input as the measurement target of the temporal waveform is converted into the optical signal of the predetermined wavelength by the light modulator 33. Further, the temporal waveform of the optical signal is measured by the waveform measurement unit 40 including the streak tube 42, and the temporal waveform of the electrical signal is obtained based on the waveform image acquired by the imaging element 44.

According to the above configuration, by performing the waveform measurement by using the streak camera including the streak tube 42 after converting the electrical signal into the optical signal, it is possible to measure the temporal waveform of the electrical signal at high speed. Further, in the above configuration, by appropriately setting the wavelength of the measurement light used for the generation of the optical signal, the waveform measurement of the optical signal by using the streak tube 42 can be suitably performed, and the temporal waveform of the electrical signal can be measured with high accuracy.

In addition, in the above configuration, the input optical system 41 which is provided at the preceding stage of the streak tube 42 in the waveform measurement unit 40 has the configuration in which the optical signal is input to the photocathode 421 as the line-shaped optical image extending in the direction intersecting with the sweep direction of the electrons in the streak tube 42. By using the above configuration, as compared with, for example, the case in which the optical signal is input to the photocathode 421 as the point-shaped optical image, the input light amount density is reduced to suppress degradation of the photocathode 421, and the measurement of the electrical signal by using the streak tube 42 can be suitably performed.

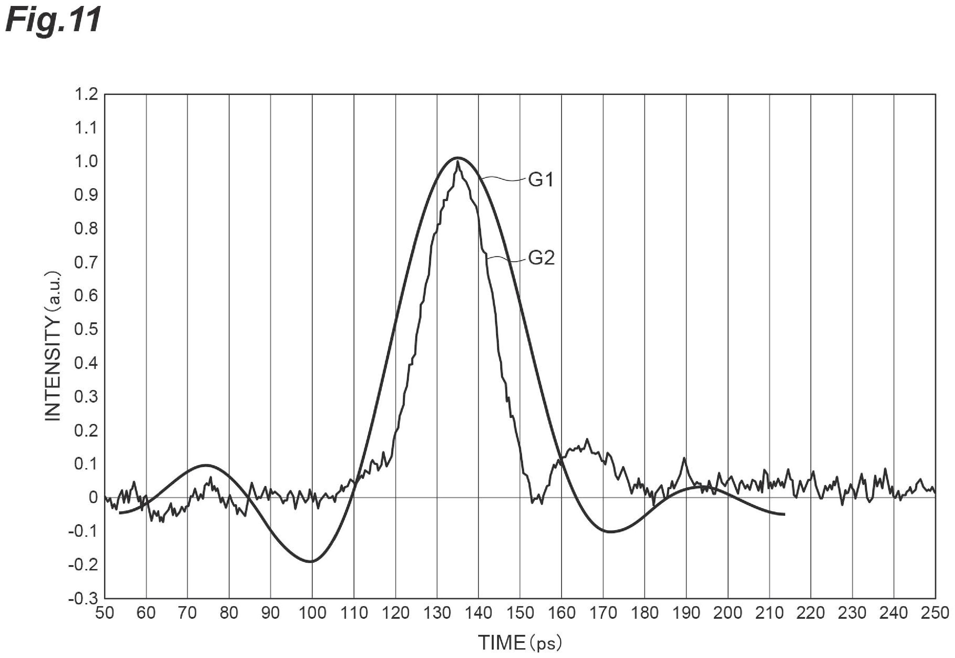

FIG. 11 is a graph showing the measurement result of the temporal waveform of the electrical signal. In the graph of FIG. 11, the horizontal axis indicates the time (ps), and the vertical axis indicates the signal intensity (a.u.). Further, in FIG. 11, a graph G1 represents the measurement result of the electrical signal measured by using a 20 GHz oscilloscope, and a graph G2 represents the measurement result measured by using the electrical signal measurement apparatus 2A of the configuration illustrated in FIG. 3.

In this case, pulsed laser light from a femtosecond laser is detected by a PIN-PD with a 40 GHz bandwidth, and an output electrical signal is measured. A wavelength of the laser light is set to 1550 nm, a repetition frequency is set to 100 MHz, and a pulse width is set to 100 fs or less. Further, in the measurement result of the graph G1, as the oscilloscope, a Tektronix DPO72004C of a 20 GHz bandwidth is used.

As for the measurement result of the graph G2, an integration rate in the streak camera of the waveform measurement unit 40 is set to 50 MHz, a frame rate is set to 60 Hz, an integration time is set to 1.6 s (100 frames with an exposure time of 10 ms), and an integration time of a base image for subtraction described later is similarly set to 1.6 s. As shown in the graph of FIG. 11, in the configuration of the above embodiment, in the measurement of the weak signal, high speed integration which is impossible with the oscilloscope is performed to suitably acquire the temporal waveform. In addition, the FWHM of the measured waveform is 31.85 ps in the graph G1, and 19.21 ps in the graph G2.

In the measurement apparatus 2A and the measurement method of the above embodiment, the electrical signal may be an electrical signal in which the temporal waveform repeats with the predetermined period (for example, the test period in the semiconductor inspection), and further, in the waveform measurement unit 40, the phosphor screen 426 of the streak tube 42 may be configured to generate the fluorescence image in which the temporal waveforms of the optical signal of the plurality of periods with respect to the predetermined period are integrated.

In this case, by performing the waveform measurement by using the streak tube 42 after converting the electrical signal into the optical signal, and integrating the temporal waveform of the optical signal in the generation of the fluorescence image by the phosphor screen 426 and the acquisition of the waveform image by the imaging element 44, a large number of integrations of the temporal waveform of the electrical signal can be performed optically at high speed. Further, the number of integrations of the temporal waveform of the optical signal in this case is preferably appropriately set according to the condition of the electrical signal of the measurement target. For example, in the streak camera, in the case in which the synchro scan at 40 MHz is performed, the number of integrations per second is determined by the test period and the like within a range of up to 40 million times per second.

In the measurement apparatus 2A and the measurement method of the above embodiment, as for the setting of the wavelength of the measurement light, as described above, it is preferable that the predetermined wavelength of the measurement light be set within a wavelength range of 115 nm or more and 1600 nm or less. By setting the wavelength of the measurement light used for the generation of the optical signal as described above, the waveform measurement of the optical signal obtained by intensity modulating the measurement light with the electrical signal by the streak tube 42 can be suitably performed, and the temporal waveform of the electrical signal can be measured with high accuracy.

In the measurement apparatus 2A and the measurement method of the above embodiment, the waveform analysis unit 52 may be configured to correct the waveform image acquired in a state in which the generation of the optical signal in the signal conversion unit 30 is set to ON based on the base image acquired in a state in which the generation of the optical signal is set to OFF. As described above, in the waveform analysis unit 52, by correcting the waveform image based on the base image, and obtaining the temporal waveform of the electrical signal by using the waveform image after the correction, the temporal waveform of the electrical signal can be measured with further improved accuracy.

The acquisition of the base image and the base correction of the waveform image by using the base image described above can be used, for example, for correction (gain correction) of variations in measurement efficiency by the position on the phosphor screen 426 of the streak tube 42 or the imaging element 44 and the like. Further, for correction of drift in measurement characteristics with time in the electrical signal measurement apparatus 2A as well, it is effective to perform the base correction as described above.

For example, the EO modulator used as the light modulator 33 in the signal conversion unit 30 has characteristic drift due to heat, and an offset may shift even when gain correction is performed. In the above case, it is preferable to implement heat dissipation measures for the light modulator 33, and in addition, perform correction of the characteristic drift with time for the waveform image acquired by the waveform measurement unit 40.

In the case in which the electrical signal measurement apparatus 2A is applied to the semiconductor inspection apparatus 1A, in the inspection apparatus 1A and the inspection method of the above embodiment, the light measurement unit 20 may include the optical amplifier 23 for amplifying and outputting the reflected light output from the inspection optical system 11, and the photodetector 25 may be configured to detect the reflected light amplified by the optical amplifier 23. Further, the photodetector 25 of the light measurement unit 20 may be the PIN-PD.

According to the above configurations, the measurement of the reflected light from the semiconductor device D by the light measurement unit 20 and the output of the electrical signal can be performed at high speed with high accuracy. That is, in the inspection of the semiconductor device D, a light amount of the probe light needs to be set such that the semiconductor device D is not damaged, and a light amount of the reflected light also becomes small. For example, in the case in which the solid immersion lens achieving an NA of 1 or more is used, an upper limit of the light amount of the probe light is about several mW, and an upper limit of the light amount of the reflected light from the semiconductor device D in this case is about 0.1 mW.

Therefore, when detecting the reflected light directly with the photodetector 25, for example, the APD is used as the photodetector 25. However, the APD has a relatively large capacitance, and is difficult to sufficiently respond to high speed signal measurement. On the other hand, by providing the optical amplifier 23 such as the SOA before the photodetector 25, it becomes possible to use, as the photodetector 25, a high speed optical sensor such as the PIN-PD, and, together with the waveform measurement by using the streak camera, the signal measurement at high speed can be suitably realized.

In the inspection apparatus 1A and the inspection method of the above embodiment, the light measurement unit 20 in the electrical signal supply unit 80 for generating and outputting the electrical signal of the measurement target may include the amplifier element such as the AC amplifier 26 for amplifying the AC component of the detection signal output from the photodetector 25, and outputting the amplified AC component as the electrical signal.

According to the above configuration, by performing the offset reset in which the DC component of the detection signal is removed and only the AC component is amplified by the AC amplifier 26 provided at the subsequent stage of the photodetector 25, the temporal change component of the intensity in the detection signal can be extracted, and further, the offset level of the electrical signal before performing the conversion into the optical signal in the signal conversion unit 30 can be appropriately adjusted and set. In addition, as the amplifier element for extracting and amplifying the AC component of the detection signal, in addition to the AC amplifier 26, for example, another element for performing removal of the DC component or extraction of the AC component may be used.

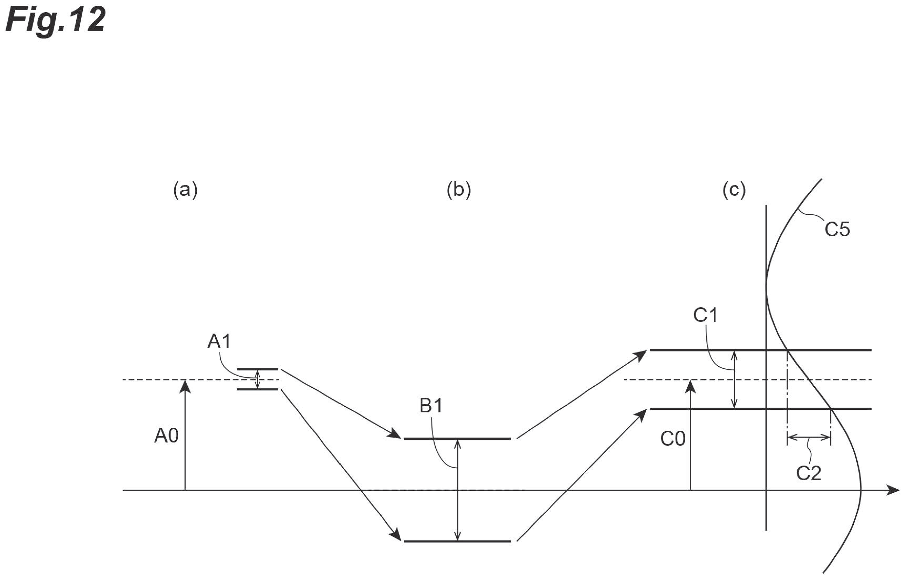

In addition, a relationship of the temporal change of the intensity of the reflected light, the temporal waveform of the electrical signal, and the temporal waveform of the optical signal in the semiconductor inspection apparatus 1A described above, and setting of the offset level of the signal will be described. FIG. 12 includes diagrams illustrating a relationship between (a) the intensity of the reflected light from the semiconductor device D, (b) the intensity of the electrical signal generated in the light measurement unit 20, and (c) the intensity of the optical signal generated in the signal conversion unit 30.

For example, in the case in which the irradiation is performed with the probe light of a wavelength of 1.3 µm, the intensity of the reflected light from the semiconductor device D is about 0.1 mW as described above. In this case, in the intensity of the reflected light illustrated in (a) in FIG. 12, when an intensity level (a DC component) A0 of the reflected light is 1, a shot noise level is 2.25% at 1σ at a 100 GHz bandwidth. On the other hand, a signal level (an AC component) A1 of the temporal change of the intensity of the reflected light used in the semiconductor inspection is very small, at 0.001% to 0.01%.

For the above reflected light, a signal level of the electrical signal generated in the light measurement unit 20 including the optical amplifier 23, the photodetector 25, and the AC amplifier 26 becomes, for example, as illustrated in (b) in FIG. 12. The detection signal output from the photodetector 25 includes a DC component and an AC component similarly to the intensity of the reflected light, and further, by removing the DC component of the detection signal in the AC amplifier 26 and amplifying only the AC component, a signal level corresponding to the intensity level A0 of the reflected light becomes nearly zero. Further, a shot noise level is about 300 mV at 1σ. On the other hand, a signal level B1 corresponding to the signal level A1 of the temporal change of the intensity of the reflected light becomes about 0.15 mV to 1.5 mV.

Further, a signal level of the optical signal generated by the intensity modulation of the measurement light in the light modulator 33 based on the above electrical signal becomes, for example, as illustrated in (c) in FIG. 12. In (c) in FIG. 12, a curve line C5 represents a relationship of a sine wave shape between the voltage of the electrical signal applied to the EO modulator constituting the light modulator 33 (the vertical axis), and the intensity of the generated optical signal (the horizontal axis).

As illustrated in (c) in FIG. 12, in the signal conversion from the electrical signal to the optical signal in the light modulator 33, in order to maximize sensitivity to the voltage change of the electrical signal and improve linearity of the signal conversion, it is preferable to apply a bias voltage as an offset as indicated by a signal level C0, and set a transmitted light amount of the measurement light at the time when the voltage of the electrical signal is zero to a predetermined light amount, for example, a light amount of 50% of a maximum transmitted light amount. In this case, an intensity change range C2 of the optical signal after the conversion can be made sufficiently wide with respect to a voltage change range C1 of the electrical signal.

Further, by the above offset adjustment in the light measurement unit 20 and the signal conversion unit 30, the measurement of the temporal change of the intensity of the reflected light and the integration of the temporal waveform can be suitably and accurately performed. In addition, a maximum value of the intensity of the optical signal is preferably appropriately set by the optical attenuator 32 or the like such that, in consideration of an upper limit value of the incident light amount density on the photocathode, the maximum value coincides with or is less than the upper limit value.

Further, FIG. 12 is in the case of the semiconductor inspection by the probe light irradiation, and in addition, the offset reset in the electrical signal of the measurement target, the offset adjustment in the signal conversion from the electrical signal to the optical signal, and the correspondence relationship between the voltage change range of the electrical signal and the intensity change range of the optical signal, and the like described above can be similarly applied to the measurement of the electrical signal other than in the semiconductor inspection. For example, for the electrical signal input as the measurement target to the signal conversion unit 30, a configuration may be used in which an element such as an amplifier element for performing the offset reset of the electrical signal is provided at the preceding stage of the signal conversion unit 30.

The setting of the number of integrations of the temporal waveform in the signal measurement by using the electrical signal measurement apparatus 2A will be described for the case in which the electrical signal measurement apparatus 2A is applied to the semiconductor inspection apparatus 1A as an example. As described above, the shot noise level in the reflected light measurement is 2.25% at a 100 GHz bandwidth, and further, 0.225% at a 1 GHz bandwidth. Further, the signal level is 0.001% to 0.01%.

In this case, for example, in order to obtain the temporal waveform with S/N of 10 or more, in the case of the signal level of 0.001% at a 1 GHz bandwidth, the required number of integrations is the square of 2250, that is, about 5 million. Further, when the bandwidth becomes tenfold, the required number of integrations also simply becomes tenfold, and for example, the required number of integrations becomes 50 million for a 10 GHz bandwidth, and the required number of integrations becomes 200 million for a 40 GHz bandwidth.

When the signal intensity with respect to the noise is high, the required number of integrations becomes smaller, and for example, when the S/N ratio becomes tenfold, the required number of integrations becomes 1/100. In addition, as a method for improving the S/N ratio, increasing the light amount to change the ratio of the shot noise and the signal can be considered, however, as described above, the light amount of the probe light needs to be set such that the semiconductor device D is not damaged. Therefore, increasing the signal intensity in this way may be difficult. In consideration of practical conditions and the like in the semiconductor inspection, it is preferable to set the number of integrations of the temporal waveform in the reflected light measurement within a range of, for example, 1 million times or more and 1 billion times or less.

A specific example of the measurement method of the temporal waveform of the electrical signal performed by using the electrical signal measurement apparatus 2A will be described. First, for the electrical signal which is the measurement target, the waveform measurement is performed by using a normal oscilloscope or the like, and the temporal waveform is acquired. Further, a measurement range for the waveform measurement by using the electrical signal measurement apparatus 2A with the streak camera is set.

Next, the temporal waveform of the electrical signal acquired by using the oscilloscope or the like is displayed on the display unit 54, and in the waveform, a measurement period (a start time and a time width of the measurement) in which actual measurement is to be performed is set and selected. Further, for the set measurement period, the measurement is performed by using the electrical signal measurement apparatus 2A, and the temporal waveform of the electrical signal is obtained in the waveform analysis unit 52, and the measurement result is displayed on the display unit 54. Further, in the case in which there are a plurality of measurement periods in which the measurement is to be performed, similar measurement is performed repeatedly a plurality of times while changing a phase as needed. Further, acquisition of the waveform image and acquisition of the base image may be alternately performed to perform the base correction such as the drift correction described above.

The configuration of the input optical system 41 in the streak camera of the waveform measurement unit 40 will be further described. As described above, it is preferable that the input optical system 41 input the optical signal to the photocathode 421 as the line-shaped optical image. As an example of a specific configuration for this purpose, in FIG. 7, the configuration of the input optical system 41 by using the cylindrical lens 410, the lens 411, and the lens 412 is illustrated, and in addition, for the configuration of the input optical system 41, various specific configurations other than the configuration illustrated in FIG. 7 can be used.

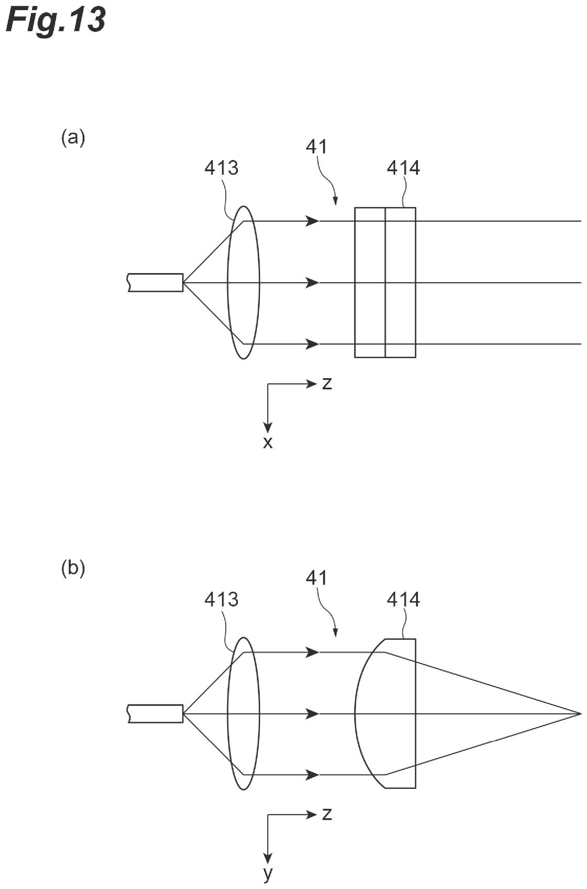

FIG. 13 includes (a) a top view and (b) a side view illustrating a first modification of a configuration of the input optical system 41 in the waveform measurement unit 40. The input optical system 41 of the first modification is configured, in order from the input side of the optical signal, by a lens 413 and a cylindrical lens 414. By using the above configuration as well, similarly to the configuration illustrated in FIG. 7, the line-shaped optical image can be formed on the photocathode 421.

In addition, in the configuration illustrated in FIG. 7 in which the cylindrical lens 410 is provided at the preceding stage side in the lens configuration of the input optical system 41, and in the configuration illustrated in FIG. 13 in which the cylindrical lens 414 is provided at the subsequent stage side, arrangement directions of the cylindrical lenses are set to be different. Further, in the configuration illustrated in FIG. 13, the cylindrical lens 414 at the subsequent stage also serves as an imaging lens.

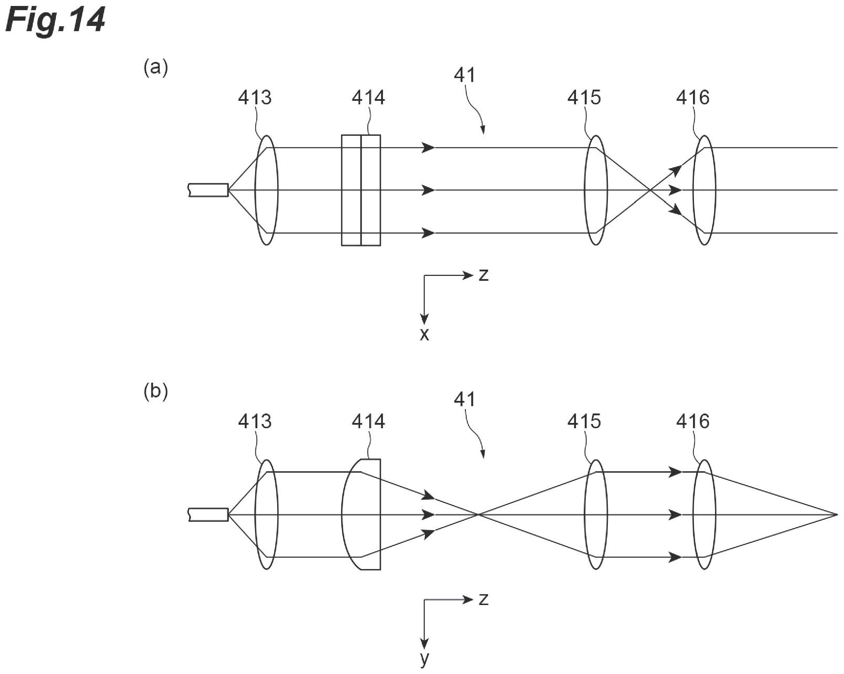

FIG. 14 includes (a) a top view and (b) a side view illustrating a second modification of a configuration of the input optical system 41 in the waveform measurement unit 40. The input optical system 41 of the second modification is configured, in order from the input side of the optical signal, by the lens 413, the cylindrical lens 414, a lens 415, and a lens 416. The configuration illustrated in FIG. 14 is a configuration obtained by adding a relay optical system including the lenses 415 and 416 to the configuration illustrated in FIG. 13.

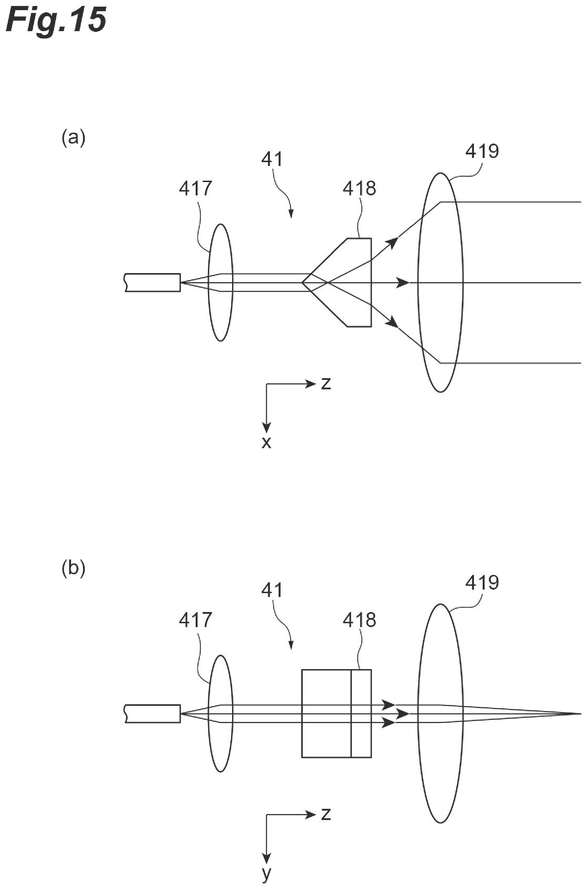

FIG. 15 includes (a) a top view and (b) a side view illustrating a third modification of a configuration of the input optical system 41 in the waveform measurement unit 40. The input optical system 41 of the third modification is configured, in order from the input side of the optical signal, by a lens 417, a Powell lens 418, and a lens 419. The Powell lens is a lens which spreads parallel light in a fan shape, and by using the Powell lens in combination with a normal lens or a cylindrical lens, a narrow and uniform line-shaped optical image can be formed.

In addition, in the configuration illustrated in FIG. 15, the lens 419 at the subsequent stage may be replaced with a combination of two cylindrical lenses having arrangement directions different from each other with axes orthogonal to each other. In this case, adjustment of the imaging position of the light becomes easy. Further, for formation of the line-shaped optical image, in addition to the cylindrical lens and the Powell lens described above, for example, a combination of an anamorphic prism pair and a slit may be used.

In general, it is preferable that the input optical system 41 of the waveform measurement unit 40 include at least one of a cylindrical lens, a Powell lens, and an anamorphic prism pair. In the input optical system 41, by using the optical element described above, the line-shaped optical image by the optical signal extending in the direction intersecting with the sweep direction (preferably, the direction orthogonal to the sweep direction) can be suitably formed.

The configuration and the operation of the electrical signal measurement apparatus described above having the configuration including the streak camera will be further described.

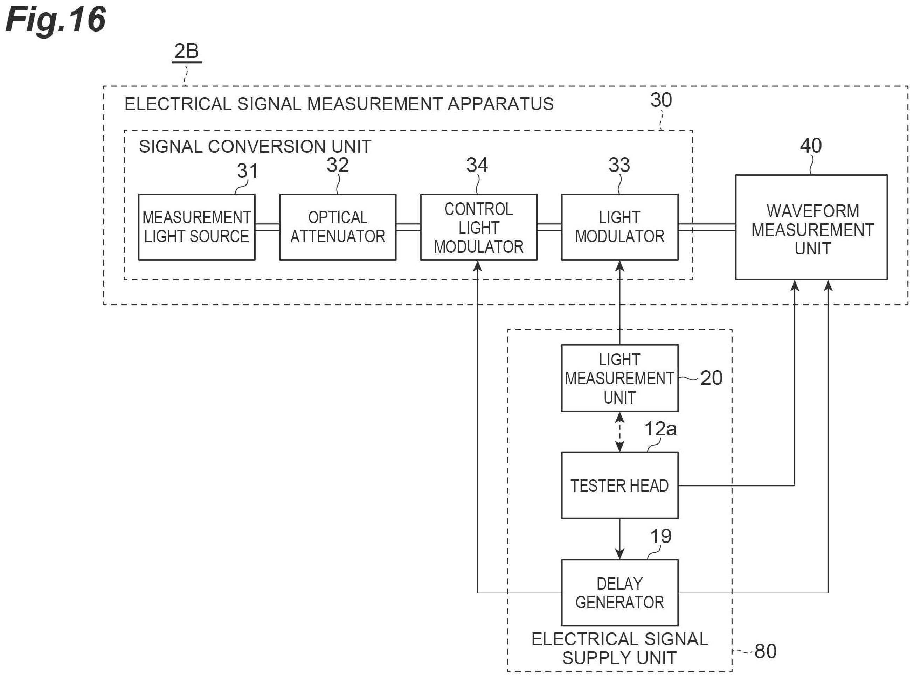

FIG. 16 is a block diagram schematically illustrating a configuration of a second embodiment of the electrical signal measurement apparatus including the signal conversion unit 30 and the waveform measurement unit 40. The configuration of the electrical signal measurement apparatus 2B according to the present embodiment is the same as the configuration illustrated in FIG. 3 for the waveform measurement unit 40, and the configuration of the signal conversion unit 30 is different. In addition, in FIG. 16, the waveform analysis unit 52 of the control apparatus 50 constituting a part of the electrical signal measurement apparatus 2B is not illustrated.

The signal conversion unit 30 includes the measurement light source 31, the optical attenuator 32, a conversion control light modulator 34, and the light modulator 33. Out of the above components, the configuration of the measurement light source 31, the optical attenuator 32, and the light modulator 33 is the same as the configuration illustrated in FIG. 3.

The conversion control light modulator 34 is provided between the optical attenuator 32 and the light modulator 33, and controls ON / OFF of the signal conversion operation from the electrical signal to the optical signal in the signal conversion unit 30 according to the measurement condition such as the test period in the semiconductor inspection unit 10. Specifically, the conversion control light modulator 34 controls ON / OFF of the signal conversion operation by switching transmission / non-transmission of the measurement light from the optical attenuator 32 based on the trigger signal input from the delay generator 19, the control signal input from the inspection control unit 51 of the control apparatus 50, or the like.

As described above, in the signal conversion unit 30, by providing the conversion control light modulator 34 separately from the light modulator 33 used for the signal conversion, various measurement controls can be performed according to specific measurement conditions in the semiconductor inspection apparatus 1A. Further, As the conversion control light modulator 34, similarly to the light modulator 33, the EO modulator, the AO modulator, the MO modulator, the Pockels cell, or the like can be used, and in particular, it is preferable to use the EO modulator.

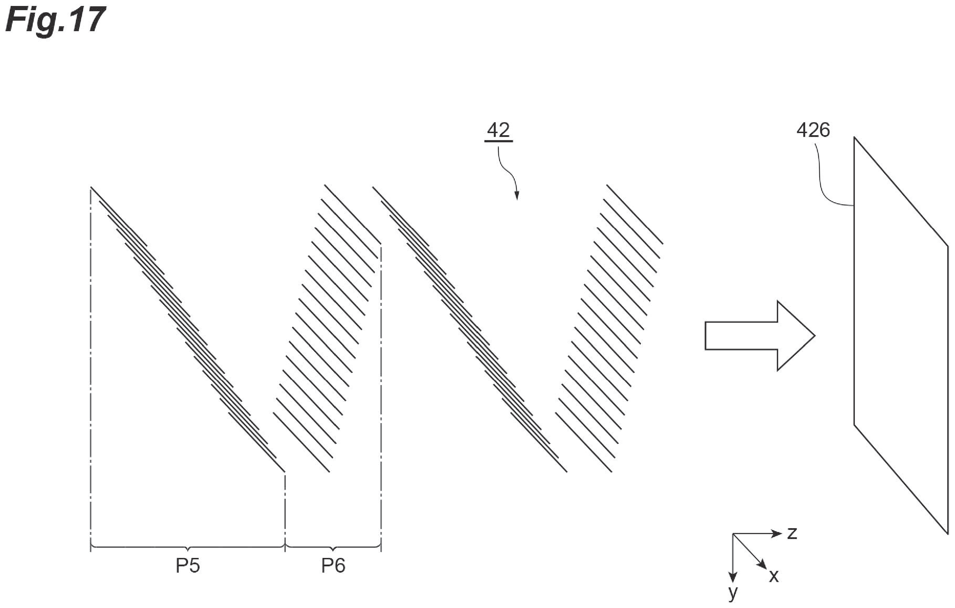

As the control of the signal conversion operation by using the conversion control light modulator 34, for example, control according to a main sweep and a return sweep in the streak tube 42 of the waveform measurement unit 40 can be performed. In addition, FIG. 17 is a diagram schematically illustrating the main sweep and the return sweep in the streak tube 42. In the streak tube 42, for example, in the synchro scan mode, the electrons are swept by the sweep voltage of the sine wave shape, and in this case, the main sweep in a normal sweep direction and the return sweep in a reverse direction are alternately repeated.

In this case, as illustrated in FIG. 17, an electron image P5 by the main sweep and an electron image P6 by the return sweep are alternately input to the phosphor screen 426, and further, when the electron image pattern by the return sweep is measured in the state in which it is superimposed on the electron image pattern by the main sweep, the measurement of the temporal waveform as the target cannot be performed correctly.

On the other hand, in the configuration illustrated in FIG. 16, in the conversion control light modulator 34 provided in the signal conversion unit 30, the control is performed such that the signal conversion operation is set to ON in a period corresponding to the main sweep in the streak tube 42, and the signal conversion operation is set to OFF in a period corresponding to the return sweep. By using the above configuration, only the electron image pattern by the main sweep can be selectively measured.

In addition, for the measurement control regarding the main sweep and the return sweep in the streak tube 42, in addition to the configuration by using the conversion control light modulator 34 of the signal conversion unit 30 as described above, various specific configurations can be used. For example, a configuration can be used in which, by applying a voltage in a predetermined pattern to the horizontal sweep electrodes 424 (see FIG. 5) in the streak tube 42, the electron image is shifted to a position outside the phosphor screen 426 in the period of the return sweep.

Further, a configuration may be used in which a high voltage applied to the streak tube 42 is modulation controlled, a voltage applied to the MCP 425 is modulation controlled, or the like. Further, a configuration may be used in which, in place of the MCP 425, an image intensifier is provided between the streak tube 42 and the output optical system 43, and ON / OFF of the image intensifier is controlled according to the main sweep and the return sweep.

In addition, in the above configurations, the optical image of the optical signal is incident on the photocathode 421 even in the period of the return sweep in which the measurement of the temporal waveform is not performed, and thus, the photocathode 421 degrades thereby. On the other hand, according to the configuration in which ON / OFF of the signal conversion operation is controlled by using the conversion control light modulator 34 in the signal conversion unit 30 as described above, the optical image of the optical signal is not incident on the photocathode 421 in the period of the return sweep, and thus, degradation of the photocathode 421 can be suppressed. In addition, as for the installation position of the conversion control light modulator 34, it is provided at the preceding stage of the light modulator 33 in FIG. 16, and further, it may be configured to be provided at the subsequent stage of the light modulator 33.

Further, as for the control of the measurement period and the measurement condition of the temporal waveform of the electrical signal in the electrical signal measurement apparatus 2B, in addition to the control of the measurement period by the conversion control light modulator 34, control may be performed for a phase in the waveform measurement. Specifically, for example, in the waveform measurement unit 40, the streak tube 42 may be configured to adjust a phase of the sweep period according to a period in which the temporal waveform of the electrical signal is to be measured. By using the above configuration as well, various measurement controls can be performed according to specific measurement conditions.

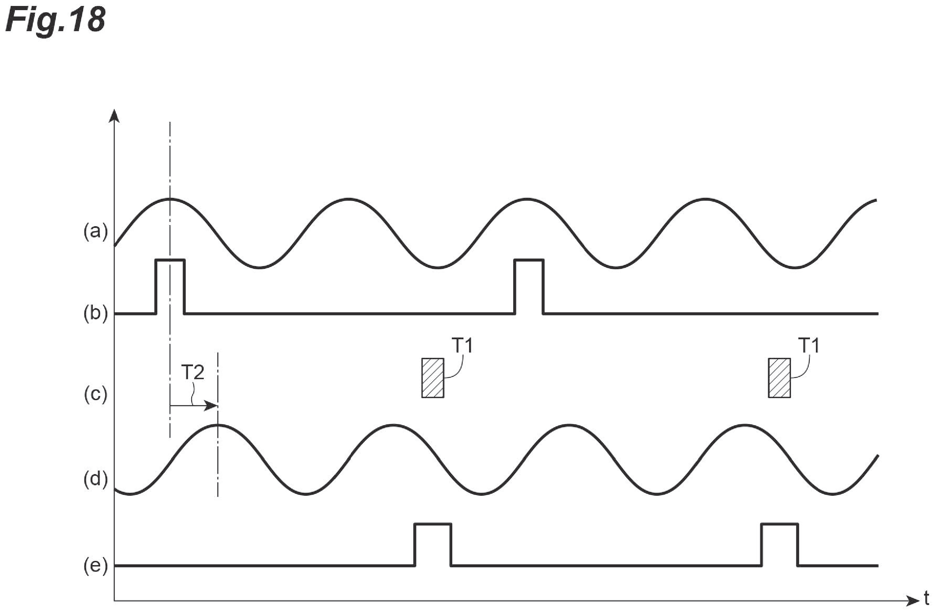

FIG. 18 is a diagram illustrating an example of setting of the measurement period and the phase of the sweep period in the streak tube. FIG. 18 illustrates, in order from the top, (a) the synchronization signal supplied from the tester head 12a, (b) the trigger signal supplied from the tester head 12a or the delay generator 19, (c) the measurement period T1 set as a period in which the waveform measurement is required in the temporal waveform of the electrical signal (the temporal change of the intensity of the reflected light), (d) the sweep voltage pattern in the streak tube 42, and (e) the control signal pattern supplied to the conversion control light modulator 34.

In the example illustrated in FIG. 18, in each test period in the semiconductor inspection unit 10, as illustrated in (c) in FIG. 18, the measurement period (measurement time window) T1 to be measured in inspecting the semiconductor device D is set. Further, according to the measurement period T1, as illustrated in (e) in FIG. 18, the control signal pattern to the conversion control light modulator 34 is determined, and thus, ON / OFF of the signal conversion operation is controlled.

Further, in the streak tube 42, as illustrated in (d) in FIG. 18, timing of the electron sweep is delayed by a time T2 from the synchronization signal such that the measurement period T1 of the temporal waveform is included in the period of the main sweep, and thus, the phase of the sweep period is adjusted. As described above, by setting the measurement period of the temporal waveform by the conversion control light modulator 34 in the signal conversion unit 30, and setting and adjusting the phase of the sweep period of the electrons in the streak tube 42, the waveform measurement can be performed under a desired condition. Further, for the adjustment of the phase described above, for example, a phase delay function of the streak camera can be used. Further, instead of the above configuration, a phase delay device may be provided on a synchronization line connecting the tester head 12a of the electrical signal supply unit 80 and the waveform measurement unit 40 to perform the adjustment of the phase described above.

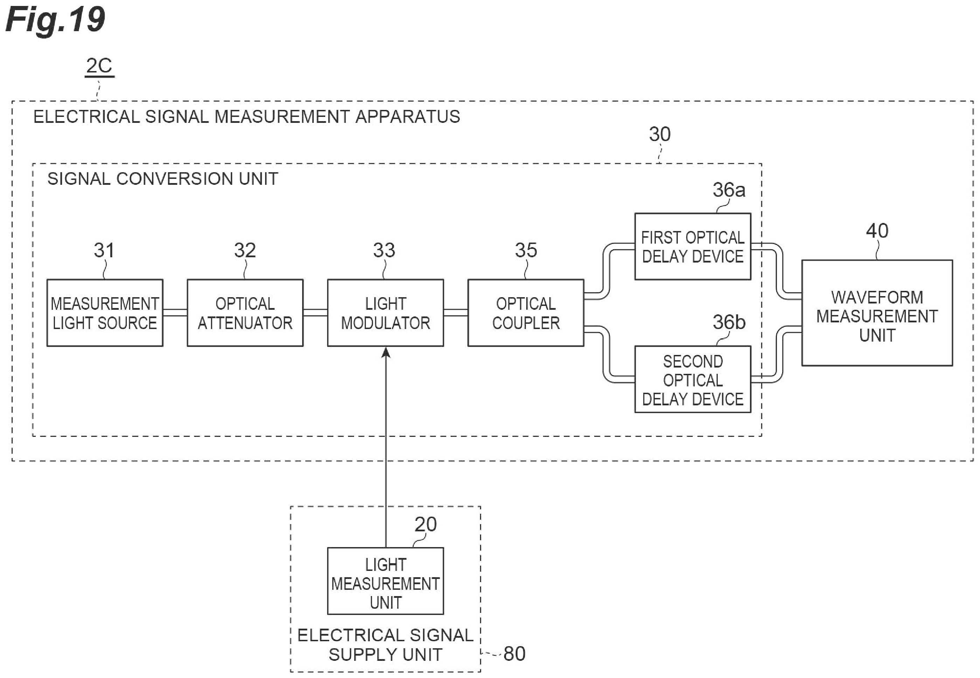

FIG. 19 is a block diagram schematically illustrating a configuration of a third embodiment of the electrical signal measurement apparatus including the signal conversion unit 30 and the waveform measurement unit 40. The configuration of the electrical signal measurement apparatus 2C according to the present embodiment is the same as the configuration illustrated in FIG. 3 for the waveform measurement unit 40, and the configuration of the signal conversion unit 30 is different. In addition, in FIG. 19, the waveform analysis unit 52 of the control apparatus 50, supply of the synchronization signal from the tester head 12a, and supply of the trigger signal from the delay generator 19 are not illustrated.

The signal conversion unit 30 includes the measurement light source 31, the optical attenuator 32, the light modulator 33, an optical coupler 35, a first optical delay device 36a, and a second optical delay device 36b. Out of the above components, the configuration of the measurement light source 31, the optical attenuator 32, and the light modulator 33 is same as the configuration illustrated in FIG. 3.

The optical coupler 35 splits the optical signal (the measurement light after the modulation) input from the light modulator 33, and outputs the split optical signals to the first optical delay device 36a and the second optical delay device 36b. The first optical delay device 36a delays the optical signal by a first delay time, and then outputs the delayed optical signal to the waveform measurement unit 40. Further, the second optical delay device 36b delays the optical signal by a second delay time, and then outputs the delayed optical signal to the waveform measurement unit 40. The first and second delay times may be different, or may be the same. Further, one of the first and second delay times may be set to zero.

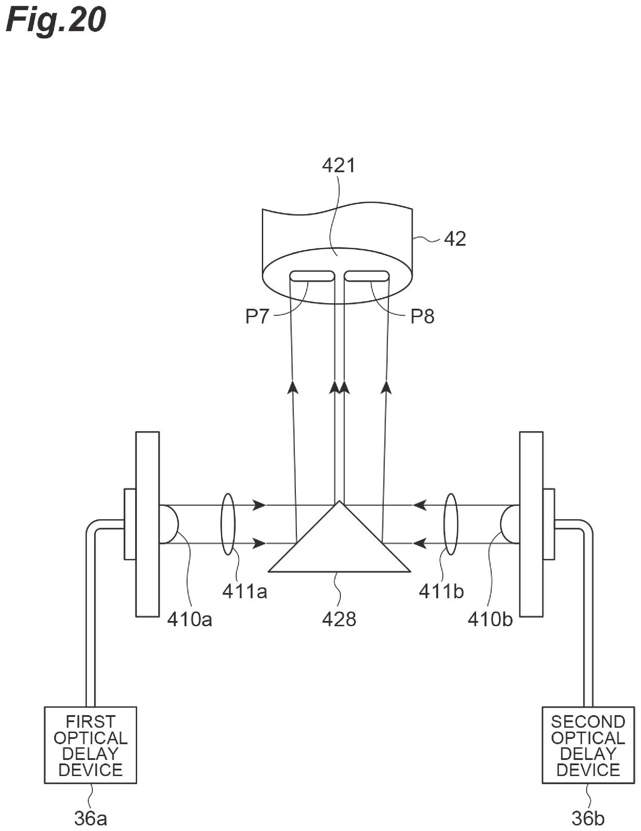

The two types of optical signals from the first and second optical delay devices 36a and 36b are preferably input to different regions on the photocathode 421 in the streak tube 42 in order to measure the respective temporal waveforms. FIG. 20 is a diagram illustrating input of the two types of optical signals to the photocathode 421 in the configuration illustrated in FIG. 19.

In the configuration illustrated in FIG. 20, the optical signal from the first optical delay device 36a is incident as an optical image P7 on a region on the left side in the diagram on the photocathode 421 via a cylindrical lens 410a, a lens 411a, and a reflection mirror 428. Further, the optical signal from the second optical delay device 36b is incident as an optical image P8 on a region on the right side in the diagram on the photocathode 421 via a cylindrical lens 410b, a lens 411b, and the reflection mirror 428. By using the above configuration, the temporal waveform can be measured for each of the optical signals from the first and second optical delay devices 36a and 36b.

As described above, in the signal conversion unit 30, by generating the two types of optical signals which respectively have the temporal waveforms corresponding to the temporal waveform of the electrical signal with conversion conditions different from each other, and in the waveform measurement unit 40, by measuring the temporal waveform of each of the above optical signals, various measurements can be performed.

For example, in the configuration illustrated in FIG. 19, the conversion control light modulator 34 in the configuration illustrated in FIG. 16 may be further provided to perform ON / OFF of the signal conversion operation, and by making the delay times in the first and second optical delay devices 36a and 36b different from each other, eye pattern observation may be performed. Further, as for the number of optical signals generated in the signal conversion unit 30, the two types of optical signals are used in the above configuration example, and in addition, a configuration in which three or more types of optical signals are generated may be used.

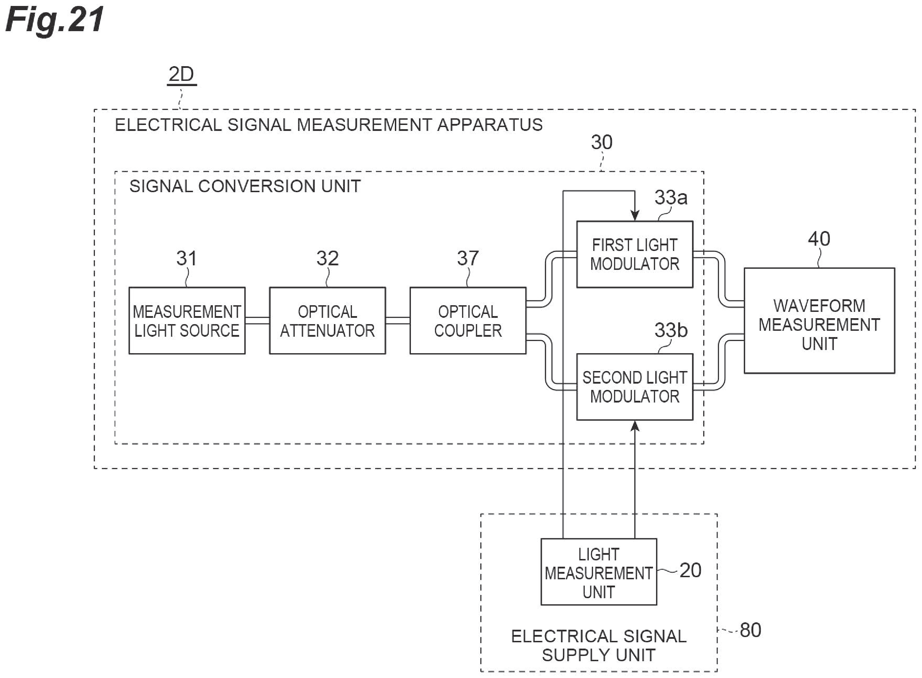

FIG. 21 is a block diagram schematically illustrating a configuration of a fourth embodiment of the electrical signal measurement apparatus including the signal conversion unit 30 and the waveform measurement unit 40. The configuration of the electrical signal measurement apparatus 2D according to the present embodiment is the same as the configuration illustrated in FIG. 3 for the waveform measurement unit 40, and the configuration of the signal conversion unit 30 is different. In addition, the waveform analysis unit 52 of the control apparatus 50 and the like are not illustrated as in FIG. 19.

The signal conversion unit 30 includes the measurement light source 31, the optical attenuator 32, an optical coupler 37, and first and second light modulators 33a and 33b. Out of the above components, the configuration of the measurement light source 31 and the optical attenuator 32 is the same as the configuration illustrated in FIG. 3.

The optical coupler 37 splits the measurement light input from the optical attenuator 32, and outputs the split light components to the first light modulator 33a and the second light modulator 33b. The electrical signal from the light measurement unit 20 is input to the first and second light modulators 33a and 33b. Each of the first and second light modulators 33a and 33b intensity modulates the measurement light based on the electrical signal input from the light measurement unit 20, and outputs the measurement light after the modulation as the optical signal having the temporal waveform corresponding to the temporal waveform of the electrical signal.

The two types of optical signals from the first and second light modulators 33a and 33b are preferably input to different regions on the photocathode 421 in the streak tube 42. Further, in the above configuration, the electrical signals respectively input to the first and second light modulators 33a and 33b may be set to signals different from each other, or an optical delay device may be provided for each of the first and second light modulators 33a and 33b. By using the above configuration as well, similarly to the configuration illustrated in FIG. 19, various measurements can be performed.

The electrical signal measurement apparatus and the electrical signal measurement method are not limited to the embodiments and configuration examples described above, and various other modifications are possible. For example, as for the specific configuration of the electrical signal measurement apparatus, it is not limited to the configurations illustrated in FIG. 3, FIG. 16, FIG. 19, and FIG. 21, and various configurations may be used. For example, in the configuration illustrated in FIG. 19 or FIG. 21, a configuration may be used in which the conversion control light modulator 34 in the configuration of FIG. 16 is further provided.

Further, in the streak tube 42 of the waveform measurement unit 40, the horizontal sweep electrodes 424 and the MCP 425 may not be provided if unnecessary. Further, as for the settings of the signal level and the offset adjustment illustrated in FIG. 12, various specific configurations may be used, according to the configuration of the electrical signal supply unit 80 and the electrical signal measurement apparatus. Further, as for the electrical signal which is the measurement target, an example in which the electrical signal measurement apparatus is applied to the semiconductor inspection apparatus is illustrated in the above description, and further, it is not limited to the above configuration, and various electrical signals can be used as the measurement target.

The electrical signal measurement apparatus of a first aspect according to the above embodiment includes (1) a signal conversion unit including a measurement light source for supplying measurement light of a predetermined wavelength, and a light modulator for intensity modulating the measurement light based on an electrical signal input as a measurement target of a temporal waveform, and for outputting the measurement light after modulation by the light modulator as an optical signal having a temporal waveform corresponding to the temporal waveform of the electrical signal; (2) a waveform measurement unit for performing measurement for the temporal waveform of the optical signal output from the signal conversion unit; and (3) a waveform analysis unit for obtaining the temporal waveform of the electrical signal based on a measurement result of the temporal waveform of the optical signal by the waveform measurement unit, and (4) the waveform measurement unit includes a streak tube including a photocathode for generating electrons in response to input of the optical signal, a sweep electrode for sweeping the electrons from the photocathode in a predetermined sweep direction with a sweep period set according to the temporal waveform of the electrical signal, and a phosphor screen for inputting the electrons swept by the sweep electrode and generating a fluorescence image indicating the temporal waveform of the optical signal; an imaging element for capturing the fluorescence image generated on the phosphor screen of the streak tube, and outputting a waveform image; and an input optical system for inputting the optical signal to the photocathode, and (5) the waveform analysis unit obtains the temporal waveform of the electrical signal based on the waveform image output from the imaging element, and (6) the input optical system of the waveform measurement unit inputs the optical signal to the photocathode as a line-shaped optical image extending in a direction intersecting with the sweep direction.

The electrical signal measurement method of a first aspect according to the above embodiment includes (1) a signal conversion step of using a light modulator for intensity modulating measurement light of a predetermined wavelength based on an electrical signal input as a measurement target of a temporal waveform, and outputting the measurement light after modulation by the light modulator as an optical signal having a temporal waveform corresponding to the temporal waveform of the electrical signal; (2) a waveform measurement step of performing measurement for the temporal waveform of the optical signal output in the signal conversion step; and (3) a waveform analysis step of obtaining the temporal waveform of the electrical signal based on a measurement result of the temporal waveform of the optical signal in the waveform measurement step, and (4) the waveform measurement step uses a streak tube including a photocathode for generating electrons in response to input of the optical signal, a sweep electrode for sweeping the electrons from the photocathode in a predetermined sweep direction with a sweep period set according to the temporal waveform of the electrical signal, and a phosphor screen for inputting the electrons swept by the sweep electrode and generating a fluorescence image indicating the temporal waveform of the optical signal, and captures the fluorescence image generated on the phosphor screen of the streak tube, and outputs a waveform image, and (5) the waveform analysis step obtains the temporal waveform of the electrical signal based on the waveform image output in the waveform measurement step, and (6) in the waveform measurement step, the optical signal is input to the photocathode as a line-shaped optical image extending in a direction intersecting with the sweep direction.

In the electrical signal measurement apparatus of a second aspect, in the configuration of the above first aspect, the electrical signal may be an electrical signal in which the temporal waveform repeats with a predetermined period, and in the waveform measurement unit, the phosphor screen of the streak tube may generate the fluorescence image in which the temporal waveforms of the optical signal of a plurality of periods with respect to the predetermined period are integrated.

In the electrical signal measurement method of a second aspect, in the configuration of the above first aspect, the electrical signal may be an electrical signal in which the temporal waveform repeats with a predetermined period, and in the waveform measurement step, the phosphor screen of the streak tube may generate the fluorescence image in which the temporal waveforms of the optical signal of a plurality of periods with respect to the predetermined period are integrated.

In the above configuration, by performing the waveform measurement by using the streak tube after converting the electrical signal into the optical signal, and integrating the temporal waveform of the optical signal in the generation of the fluorescence image by the phosphor screen and the acquisition of the waveform image by the imaging element, a large number of integrations of the temporal waveform of the electrical signal can be performed optically at high speed.

In the electrical signal measurement apparatus of a third aspect, in the configuration of the above first or second aspect, the input optical system of the waveform measurement unit may include at least one of a cylindrical lens, a Powell lens, and an anamorphic prism pair.

In the input optical system of the waveform measurement unit, by using the optical element described above, the line-shaped optical image extending in the direction intersecting with the sweep direction by the optical signal can be suitably formed.

In the electrical signal measurement apparatus of a fourth aspect, in the configuration of any one of the above first to third aspects, the light modulator of the signal conversion unit may be an EO modulator.

As described above, by using the EO modulator as the light modulator for intensity modulating the measurement light, the conversion of the electrical signal into the optical signal can be suitably performed.

In the electrical signal measurement apparatus of a fifth aspect, in the configuration of any one of the above first to fourth aspects, the signal conversion unit may include a conversion control light modulator for controlling ON / OFF of a signal conversion operation from the electrical signal to the optical signal according to the temporal waveform of the electrical signal.

In the electrical signal measurement method of a third aspect, in the configuration of the above first or second aspect, in the signal conversion step, a conversion control light modulator for controlling ON / OFF of a signal conversion operation from the electrical signal to the optical signal according to the temporal waveform of the electrical signal may be used.

In this case, in the electrical signal measurement apparatus of a sixth aspect, in the configuration of the above fifth aspect, the conversion control light modulator of the signal conversion unit may set the signal conversion operation ON in a period corresponding to a main sweep in the streak tube, and may set the signal conversion operation OFF in a period corresponding to a return sweep.

Further, in the electrical signal measurement method of a fourth aspect, in the configuration of the above third aspect, in the signal conversion step, the conversion control light modulator may set the signal conversion operation ON in a period corresponding to a main sweep in the streak tube, and may set the signal conversion operation OFF in a period corresponding to a return sweep.

As described above, in the signal conversion unit, by providing the conversion control light modulator in addition to the light modulator used for the signal conversion, various measurement controls can be performed according to specific measurement conditions, such as controlling ON / OFF of the signal conversion operation according to the main sweep and the return sweep in the streak tube as described above. Further, as the conversion control light modulator, similarly to the light modulator for the signal conversion, for example, the EO modulator can be suitably used.

In the electrical signal measurement apparatus of a seventh aspect, in the configuration of any one of the above first to sixth aspects, in the waveform measurement unit, the streak tube may adjust a phase of the sweep period according to a period in which the temporal waveform of the electrical signal is to be measured.

In the electrical signal measurement method of a fifth aspect, in the configuration of any one of the above first to fourth aspects, in the waveform measurement step, the streak tube may adjust a phase of the sweep period according to a period in which the temporal waveform of the electrical signal is to be measured.

As described above, by using the configuration in which the phase of the sweep period is adjusted in the streak tube of the waveform measurement unit also, various measurement controls can be performed according to specific measurement conditions.

In the electrical signal measurement apparatus of an eighth aspect, in the configuration of any one of the above first to seventh aspects, the signal conversion unit may generate, as the optical signal, two or more types of optical signals which respectively have temporal waveforms corresponding to the temporal waveform of the electrical signal with conversion conditions different from each other.

In the electrical signal measurement method of a sixth aspect, in the configuration of any one of the above first to fifth aspects, in the signal conversion step, as the optical signal, two or more types of optical signals which respectively have temporal waveforms corresponding to the temporal waveform of the electrical signal with conversion conditions different from each other may be generated.

As described above, by generating the two or more types of optical signals different from each other in the signal conversion unit, and measuring the temporal waveform of each of the above optical signals in the waveform measurement unit, various measurements can be performed, for example, performing eye pattern observation by measuring the two types of optical signals having delay times different from each other.

In the electrical signal measurement apparatus of a ninth aspect, in the configuration of any one of the above first to eighth aspects, the predetermined wavelength of the measurement light may be set within a wavelength range of 115 nm or more and 1600 nm or less.

In the electrical signal measurement method of a seventh aspect, in the configuration of any one of the above first to sixth aspects, the predetermined wavelength of the measurement light may be set within a wavelength range of 115 nm or more and 1600 nm or less.

By setting the wavelength of the measurement light used for the generation of the optical signal as described above, the waveform measurement of the optical signal obtained by intensity modulating the measurement light with the electrical signal by the streak tube can be suitably performed, and the temporal waveform of the electrical signal can be measured with high accuracy.

In the electrical signal measurement apparatus of a tenth aspect, in the configuration of any one of the above first to ninth aspects, the waveform analysis unit may correct the waveform image acquired in a state in which generation of the optical signal in the signal conversion unit is set to ON based on a base image acquired in a state in which generation of the optical signal is set to OFF.

In the electrical signal measurement method of an eighth aspect, in the configuration of any one of the above first to seventh aspects, in the waveform analysis step, the waveform image acquired in a state in which generation of the optical signal in the signal conversion step is set to ON may be corrected based on a base image acquired in a state in which generation of the optical signal is set to OFF.

As described above, by correcting the waveform image based on the base image, and obtaining the temporal waveform of the electrical signal by using the waveform image after the correction, the temporal waveform of the electrical signal can be measured with further improved accuracy.

### Industrial Applicability

The embodiments can be used as an electrical signal measurement apparatus and an electrical signal measurement method capable of measuring a temporal waveform of an electrical signal at high speed.

### Reference Signs List

1A - semiconductor inspection apparatus, 2A - 2D - electrical signal measurement apparatus, D - semiconductor device, 10 - semiconductor inspection unit, 11 - inspection optical system, 12 - voltage application unit, 12a - tester head, 12b - test board, 13 - dark box, 14 - stage, 15 - scanning optical system, 16 - imaging optical system, 17 - objective lens, 18 - turret, 19 - delay generator, 20 - light measurement unit, 21 - probe light source, 22 - optical coupler, 23 - optical amplifier, 24 - optical splitter, 25 - photodetector, 26 - AC amplifier,
30 - signal conversion unit, 31 - measurement light source, 32 - optical attenuator, 33 - light modulator, 33a - first light modulator, 33b - second light modulator, 34 - conversion control light modulator, 35 - optical coupler, 36a - first optical delay device, 36b - second optical delay device, 37 - optical coupler, 40 - waveform measurement unit, 41 - input optical system, 42 - streak tube, 43 - output optical system, 44 - imaging element, 45 - synchronization unit, 50 - control apparatus, 51 - inspection control unit, 52 - waveform analysis unit, 53 - input unit, 54 - display unit, 55 - scanning control unit, 61 - second light measurement unit, 62 - second waveform measurement unit, 63 - frequency analysis unit,
330 - EO crystal, 331 - input optical waveguide, 332 - first splitting optical waveguide, 333 - second splitting optical waveguide, 334 - output optical waveguide, 335 - RF electrode, 336 - bias electrode, 337a - 337d - ground electrode,
410, 414 - cylindrical lens, 418 - Powell lens, 411, 412, 413, 415, 416, 417, 419 - lens, 430, 431 - lens,
420 - outer tube, 421 - photocathode, 422 - accelerating electrode, 423 - vertical sweep electrode, 424 - horizontal sweep electrode, 425 - MCP, 426 - phosphor screen, 428 - reflection mirror,
80 - electrical signal supply unit, 81 - electrical signal output unit, 82 - synchronization signal output unit, 83 - trigger signal output unit.

## Claims

1. An electrical signal measurement apparatus comprising:
a signal conversion unit including a measurement light source for supplying measurement light of a predetermined wavelength, and a light modulator for intensity modulating the measurement light based on an electrical signal input as a measurement target of a temporal waveform, and for outputting the measurement light after modulation by the light modulator as an optical signal having a temporal waveform corresponding to the temporal waveform of the electrical signal;
a waveform measurement unit for performing measurement for the temporal waveform of the optical signal output from the signal conversion unit; and
a waveform analysis unit for obtaining the temporal waveform of the electrical signal based on a measurement result of the temporal waveform of the optical signal by the waveform measurement unit, wherein
the waveform measurement unit includes:
a streak tube including a photocathode for generating electrons in response to input of the optical signal, a sweep electrode for sweeping the electrons from the photocathode in a predetermined sweep direction with a sweep period set according to the temporal waveform of the electrical signal, and a phosphor screen for inputting the electrons swept by the sweep electrode and generating a fluorescence image indicating the temporal waveform of the optical signal;
an imaging element for capturing the fluorescence image generated on the phosphor screen of the streak tube, and outputting a waveform image; and
an input optical system for inputting the optical signal to the photocathode, and wherein
the waveform analysis unit obtains the temporal waveform of the electrical signal based on the waveform image output from the imaging element, and
the input optical system of the waveform measurement unit inputs the optical signal to the photocathode as a line-shaped optical image extending in a direction intersecting with the sweep direction.

2. The electrical signal measurement apparatus according to claim 1, wherein the electrical signal is an electrical signal in which the temporal waveform repeats with a predetermined period, and
in the waveform measurement unit, the phosphor screen of the streak tube generates the fluorescence image in which the temporal waveforms of the optical signal of a plurality of periods with respect to the predetermined period are integrated.

3. The electrical signal measurement apparatus according to claim 1 or 2, wherein the input optical system of the waveform measurement unit includes at least one of a cylindrical lens, a Powell lens, and an anamorphic prism pair.

4. The electrical signal measurement apparatus according to any one of claims 1 to 3, wherein the light modulator of the signal conversion unit is an EO modulator.

5. The electrical signal measurement apparatus according to any one of claims 1 to 4, wherein the signal conversion unit includes a conversion control light modulator for controlling ON / OFF of a signal conversion operation from the electrical signal to the optical signal according to the temporal waveform of the electrical signal.

6. The electrical signal measurement apparatus according to claim 5, wherein the conversion control light modulator of the signal conversion unit sets the signal conversion operation ON in a period corresponding to a main sweep in the streak tube, and sets the signal conversion operation OFF in a period corresponding to a return sweep.

7. The electrical signal measurement apparatus according to any one of claims 1 to 6, wherein in the waveform measurement unit, the streak tube adjusts a phase of the sweep period according to a period in which the temporal waveform of the electrical signal is to be measured.

8. The electrical signal measurement apparatus according to any one of claims 1 to 7, wherein the signal conversion unit generates, as the optical signal, two or more types of optical signals which respectively have temporal waveforms corresponding to the temporal waveform of the electrical signal with conversion conditions different from each other.

9. The electrical signal measurement apparatus according to any one of claims 1 to 8, wherein the predetermined wavelength of the measurement light is set within a wavelength range of 115 nm or more and 1600 nm or less.

10. The electrical signal measurement apparatus according to any one of claims 1 to 9, wherein the waveform analysis unit corrects the waveform image acquired in a state in which generation of the optical signal in the signal conversion unit is set to ON based on a base image acquired in a state in which generation of the optical signal is set to OFF.

11. An electrical signal measurement method comprising:
a signal conversion step of using a light modulator for intensity modulating measurement light of a predetermined wavelength based on an electrical signal input as a measurement target of a temporal waveform, and outputting the measurement light after modulation by the light modulator as an optical signal having a temporal waveform corresponding to the temporal waveform of the electrical signal;
a waveform measurement step of performing measurement for the temporal waveform of the optical signal output in the signal conversion step; and
a waveform analysis step of obtaining the temporal waveform of the electrical signal based on a measurement result of the temporal waveform of the optical signal in the waveform measurement step, wherein
the waveform measurement step uses a streak tube including a photocathode for generating electrons in response to input of the optical signal, a sweep electrode for sweeping the electrons from the photocathode in a predetermined sweep direction with a sweep period set according to the temporal waveform of the electrical signal, and a phosphor screen for inputting the electrons swept by the sweep electrode and generating a fluorescence image indicating the temporal waveform of the optical signal, and captures the fluorescence image generated on the phosphor screen of the streak tube, and outputs a waveform image, and wherein
the waveform analysis step obtains the temporal waveform of the electrical signal based on the waveform image output in the waveform measurement step, and
in the waveform measurement step, the optical signal is input to the photocathode as a line-shaped optical image extending in a direction intersecting with the sweep direction.

12. The electrical signal measurement method according to claim 11, wherein the electrical signal is an electrical signal in which the temporal waveform repeats with a predetermined period, and
in the waveform measurement step, the phosphor screen of the streak tube generates the fluorescence image in which the temporal waveforms of the optical signal of a plurality of periods with respect to the predetermined period are integrated.

13. The electrical signal measurement method according to claim 11 or 12, wherein in the signal conversion step, a conversion control light modulator for controlling ON / OFF of a signal conversion operation from the electrical signal to the optical signal according to the temporal waveform of the electrical signal is used.

14. The electrical signal measurement method according to claim 13, wherein in the signal conversion step, the conversion control light modulator sets the signal conversion operation ON in a period corresponding to a main sweep in the streak tube, and sets the signal conversion operation OFF in a period corresponding to a return sweep.

15. The electrical signal measurement method according to any one of claims 11 to 14, wherein in the waveform measurement step, the streak tube adjusts a phase of the sweep period according to a period in which the temporal waveform of the electrical signal is to be measured.

16. The electrical signal measurement method according to any one of claims 11 to 15, wherein in the signal conversion step, as the optical signal, two or more types of optical signals which respectively have temporal waveforms corresponding to the temporal waveform of the electrical signal with conversion conditions different from each other are generated.

17. The electrical signal measurement method according to any one of claims 11 to 16, wherein the predetermined wavelength of the measurement light is set within a wavelength range of 115 nm or more and 1600 nm or less.

18. The electrical signal measurement method according to any one of claims 11 to 17, wherein in the waveform analysis step, the waveform image acquired in a state in which generation of the optical signal in the signal conversion step is set to ON is corrected based on a base image acquired in a state in which generation of the optical signal is set to OFF.
